(19) Europäisches Patentamt
European Patent Office
Office européen des brevets

(11) EP 0 936 230 A1

(12) # EUROPEAN PATENT APPLICATION
published in accordance with Art. 158(3) EPC

(43) Date of publication:
**18.08.1999 Bulletin 1999/33**

(21) Application number: **97909677.3**

(22) Date of filing: **29.10.1997**

(51) Int. Cl.$^6$: **C08F 277/00**, C08F 8/00, C08L 51/00, C08J 5/18, C08J 5/24, B32B 15/08

(86) International application number:
**PCT/JP97/03933**

(87) International publication number:
**WO 98/18837 (07.05.1998 Gazette 1998/18)**

(84) Designated Contracting States:
**CH DE FI FR GB LI**

(30) Priority: **29.10.1996 JP 30372896**
**29.11.1996 JP 33490196**

(71) Applicant: **NIPPON ZEON CO., LTD.**
**Tokyo 100 (JP)**

(72) Inventors:
- **HOSAKA, Tohru,**
**Research & Development Center**
**Kawasaki-ku, Kawasaki-shi Kanagawa 210 (JP)**
- **WAKIZAKA, Yasuhiro,**
**Research & Development Center**
**Kawasaki-ku, Kawasaki-shi Kanagawa 210 (JP)**
- **MISAWA, Mari,**
**Research & Development Center**
**Kawasaki-ku, Kawasaki-shi Kanagawa 210 (JP)**
- **KODEMURA, Junji,**
**Research & Development Center**
**Kawasaki-ku, Kawasaki-shi Kanagawa 210 (JP)**

(74) Representative:
**Hucker, Charlotte Jane**
**Gill Jennings & Every**
**Broadgate House,**
**7 Eldon Street**
**London EC2M 7LH (GB)**

(54) **MODIFIED THERMOPLASTIC NORBORNENE POLYMER AND PROCESS FOR THE PRODUCTION THEREOF**

(57) A modified thermoplastic norbornene polymer obtained by graft-modifying a norbornene addition polymer with at least one unsaturated compound selected from the group consisting of unsaturated epoxy compounds and unsaturated carboxylic compounds, and having a rate of graft modification of 3 to 50 mol% when graft-modified with an unsaturated epoxy compound or a rate of graft modification of 7 to 50 mol% when graft-modified with an unsaturated carboxylic compound, and a number average molecular weight (Mn) of 500 to 500,000, a production process thereof, and a crosslinking polymer composition comprising the modified thermoplastic norbornene polymer and a crosslinking agent.

EP 0 936 230 A1

## Description

〈TECHNICAL FIELD〉

The present invention relates to modified thermoplastic norbornene polymers obtained by graft-modifying an addition polymer of a norbornene monomer with an unsaturated epoxy compound or unsaturated carboxylic compound, and a production process thereof, and more particularly to modified thermoplastic norbornene polymers which are excellent in electrical properties such as dielectric constant, adhesion property to other materials such as metals (metal foils, metallic wirings, etc.) and silicon wafers, heat resistance, moisture resistance, etc., can be prepared into high-concentration solutions, and are also excellent in the ability to uniformly disperse various kinds of compounding additives in such a solution, and a production process thereof.

The modified thermoplastic norbornene polymers according to the present invention are suitable for use in a field of electrical apparatus and electronic equipment as, for example, impregnating resins for prepregs, sheets, interlayer insulating films and the like making good use of these excellent various properties.

〈BACKGROUND ART〉

With the rapid advancement of advanced information-oriented society in recent years, there is a strong demand for the speeding up of information processing and the miniaturization of apparatus or devices in a field of the electronic industry. In electronic parts used in electrical apparatus and electronic equipment, such as semiconductors, ICs, hybrid ICs, printed boards, display devices and display parts, insulating materials having a sufficiently low dielectric constant in a high-frequency region are required for the purpose of realizing the speeding up and miniaturization in the high-frequency region. In order to ensure high reliability over a long period of time, insulating materials also excellent in heat resistance such as soldering heat resistance, and moisture resistance are also required. Further, the speeding up of information processing is pressed in a field of information processing apparatus such as computers and communication apparatus. In addition, their miniaturization and weight saving are required so as to be portable. In keeping with such requirements, it is strongly required of circuits installed in these apparatus to make circuit boards high performance such as multi-layer structure, high precision and minute processing.

In recent years, there has been developed a multi-chip module (MCM) for flip chip mounting, by which miniaturized and high-density packaging has been realized. In order to ensure high reliability over a long period of time, an insulating material used in an interlayer insulating film for this MCM is required to have, in addition to the above required properties, sufficient adhesion property to substrates such as silicon wafers, and conducting layers such as metal layers (metal foils, metallized films, etc.), since MCM is fabricated by laying many insulating layers and conductive layers on one another on a substrate such as a silicon wafer. In addition, since to be able to make a via diameter small by reduction in wiring pitch is require of MCM, it is required to impart photosensitivity to the insulating material in order to make minute processing possible.

As insulating materials for MCM, there have heretofore been investigated materials obtained by imparting photosensitivity to a polyimide resin or epoxy resin. However, the conventional photosensitive polyimide resins are insufficient in electrical properties such as dielectric constant in a high-frequency region and also in moisture resistance and hence have involved a drawback that it is difficult to cope with the achievement of high reliability over a long period of time. In the epoxy resins, it has been attempted to introduce a photosensitive group such as an allyl group therein to impart photosensitivity to the resins. However, such an attempt has involved a drawback that electrical properties, such as dielectric constant, of the resultant resins are deteriorated to a great extent, and their heat stability also become insufficient.

On the other hand, a circuit board is produced by impregnating a reinforcing base material, for example, a glass cloth, with a resin varnish, drying the varnish to form a sheet (prepreg) in a semi-cured state, laying up a copper foil or outer copper-clad sheet, the prepreg, an inner copper-clad sheet, and the like in that order between mirror plates and then hot-pressing the resultant laminate to completely cure the resin. As a resin material, there has heretofore been used a phenol resin, epoxy resin, polyimide resin, fluororesin, polybutadiene resin or the like.

However, the dielectric constant of thermosetting resins such as the phenol resin, epoxy resin and polyimide resin is generally as high as at least 4.0, and so their electrical properties are insufficient. Therefore, circuit boards making use of these thermosetting resins have been difficult to achieve the speeding up and high reliability of arithmetic processing. On the other hand, circuit boards making use of thermoplastic resins such as the fluororesins and polybutadiene resins are poor in heat resistance and so may cause cracking and/or delamination in some cases upon soldering or the like. In addition, such resins have also been difficult to form a multi-layer structure due to their poor dimensional stability.

Accordingly, in recent years, it has been proposed to use thermoplastic norbornene resins as insulating materials.

For example, Japanese Patent Application Laid-Open No. 34924/1987 discloses a process comprising synthesizing a norbornene resin having an intrinsic viscosity [η] of 1.15 to 2.22 as measured at 135°C in decalin by addition polymerization of a norbornene type cycloolefin and ethylene, kneading the norbornene resin and a crosslinking aid, grinding the resultant mixture, impregnating the ground mixture with a solution of an organic peroxide, removing the solution and then press molding it to crosslink the resin.

However, this process has involved problems that the process is complicated, and besides it is difficult to prepare a high-concentration solution of the norbornene resin, and the organic peroxide and other compounding additives are not uniformly dispersed. Accordingly, it is necessary to prepare a low-concentration solution in order to produce a prepreg using a solution of the resin obtained by this process. When the reinforcing base material is impregnated with the low-concentration solution, however, it takes a long time to dry the solution until it becomes tack-free at room temperature, and so the base material must be left at rest so as not to deform in the meantime. Therefore, this process involves a problem of poor productivity. In addition, various kinds of compounding additives must be added according to various uses. However, such compounding additives cannot be uniformly dispersed in the resin solution due to the high viscosity of the solution, and there is also an disadvantage that the resin solution and the compounding additives undergo phase separation from each other according to the kinds and compounding amounts of the compounding additives used. If the reinforcing base material is impregnated with the solution phase-separated into 2 phases, any prepreg in which the individual components are uniformly dispersed cannot be obtained. In addition, if a copper foil is laminated on the thus-obtained molding such as the prepreg, the resultant laminate has no sufficient peel strength and hence involves a problem of durability.

Japanese Patent Application Laid-Open No. 248164/1994 discloses a process in which a hydrogenated thermoplastic ring-opening norbornene resin, an organic peroxide, a crosslinking aid and a flame retardant such as brominated bisphenol are dispersed in a solvent, and casting is conducted using the resultant solution, or a reinforcing base material is impregnated with the solution, and the solvent is then removed to crosslinking the resin by heating, thereby producing a sheet, prepreg or the like. When the norbornene resin specifically disclosed in this publication is used, however, it is difficult to make the solids concentration of a solution sufficiently high, and so productivity in a drying step becomes insufficient. In addition, this process has involved a problem that it cannot be fully applied according to use fields, since the kinds and amounts of compounding additives which can be uniformly dispersed in such a solution are limited, and moreover the peel strength of the resin to a copper film is insufficient.

Japanese Patent Application Laid-Open No. 27417/1987 has proposed modified cycloolefin copolymers obtained by grafting an unsaturated epoxy compound such as allyl glycidyl ether on an addition copolymer of ethylene and a norbornene monomer. This resin material has been reported to be excellent in electrical properties, heat resistance, adhesion property, etc. However, the modified polymers specifically disclosed in this prior art document are all insufficient in the rate of graft modification. Therefore, they are insufficient in adhesion property to other materials such as metals and silicon wafers and moreover in heat resistance, and hence have involved a problem that deformation and cracking tend to occur in a solder reflowing step or a sputtering step.

On the other hand, Japanese Patent Application Laid-Open No. 298510/1990 discloses that carbon-carbon unsaturated bonds in a norbornene addition polymer obtained by the addition polymerization of ethylidene-norbornene or dicyclopentadiene are completely epoxidized, thereby obtaining an epoxy group-containing norbornene addition polymer useful as a sealing material. However, this epoxy group-containing norbornene addition polymer is too high in epoxy group content, and so it is insufficient in electrical properties such as dielectric constant, and moisture resistance to use it as an insulating material for MCM and the like. In addition, the epoxidation of carbon-carbon double bonds tends to leave many carbon-carbon double bonds intact. Therefore, such an addition polymer is insufficient in heat stability and electrical properties such as dielectric constant.

Further, Japanese Patent Application Laid-Open No. 172423/1994 discloses an epoxy group-containing norbornene addition copolymer obtained by epoxidizing carbon-carbon double bonds in an addition copolymer of dicyclopentadiene and propylene with a peroxide. This polymer is improved in hydrophilic nature and adhesive property to some extent. However, the polymer is too poor in heat resistance to use as an insulating material for MCM and the like, and is not sufficient in adhesion property to a metal used as a conductive layer, either.

〈DISCLOSURE OF THE INVENTION〉

It is an object of the present invention to provide modified thermoplastic norbornene polymers which are excellent in electrical properties such as dielectric constant in a high-frequency region, heat resistance, moisture resistance and heat stability and also in adhesion property to other materials such as metals and silicon wafers, and a production process thereof.

Another object of the present invention is to provide crosslinking polymer compositions comprising an epoxy group-containing norbornene polymer which is excellent in electrical properties such as dielectric constant in a high-frequency region, heat resistance, moisture resistance and heat stability and also in adhesion property to other materials such as metals and silicon wafers, and is also suitable for blending of a crosslinking agent.

A further object of the present invention is to provide modified thermoplastic norbornene polymers which are excellent in heat resistance, electrical properties such as dielectric constant, and peel strength to metal foils, can be prepared into high-concentration solutions, and are also excellent in the ability to uniformly disperse compounding additives in such a solution, a production process thereof, and crosslinking polymer compositions comprising such a modified thermoplastic norbornene polymer and a crosslinking agent.

The present inventors have carried out an extensive investigation with a view toward overcoming the above-described problems involved in the prior art. As a result, it has been found that the above objects can be achieved by modified thermoplastic norbornene polymers obtained by graft-modifying a norbornene addition polymer having specific repeating units with at least one unsaturated compound selected from the group consisting of unsaturated epoxy compounds and unsaturated carboxylic compounds in the presence of an organic peroxide.

The modified thermoplastic norbornene polymers according to the present invention have excellent heat resistance, exhibit an excellent dielectric constant in a high-frequency region, are sufficiently improved in adhesion property to other materials such as metals and silicon wafers without impairing their good moisture resistance, further have the good ability to disperse a photosensitive crosslinking agent and the like therein and moreover are scarcely deteriorated in electrical properties such as dielectric constant even when they are photo-set.

In addition, the modified thermoplastic norbornene polymers according to the present invention can be prepared into high-concentration solutions, and various compounding additives can be uniformly dispersed at a high concentration in such a solution. Since such a solution is excellent in the ability to impregnate reinforcing base materials and also good in film-forming property, prepregs and sheets can be produced by using a crosslinking polymer composition comprising such a modified thermoplastic norbornene polymer and a crosslinking agent. In addition, laminates produced from the prepregs or sheets are excellent in heat resistance and dielectric constant, and moreover a laminate excellent in peel strength to a metal layer can be provided when the metal layer is laminated on such a prepreg or sheet.

The present invention has been led to completion on the basis of these findings.

According to the present invention, there is thus provided a modified thermoplastic norbornene polymer obtained by graft-modifying a norbornene addition polymer having repeating units [A] represented by the formula (A1):

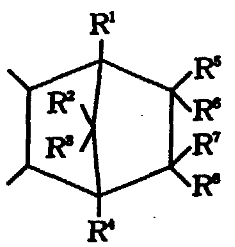

(A1)

wherein $R^1$ to $R^8$ are independently a hydrogen atom, hydrocarbon group, halogen atom, alkoxy group, ester group, cyano group, amide group, imide group, silyl group or hydrocarbon group substituted by a polar group (i.e., a halogen atom, alkoxy group, ester group, cyano group, amide group, imide group or silyl group),

with the proviso that at least two of $R^5$ to $R^8$ may be bonded to each other to form a monocycle or polycycle, the monocycle or polycycle may have carbon-carbon double bond(s) or be in the form of an aromatic ring, and $R^5$ and $R^6$, or $R^7$ and $R^8$ may form an alkylidene group, with at least one unsaturated compound selected from the group consisting of unsaturated epoxy compounds and unsaturated carboxylic compounds, wherein the modified polymer has a rate of graft modification of 3 to 50 mol% when graft-modified with an unsaturated epoxy compound or a rate of graft modification of 7 to 50 mol% when graft-modified with an unsaturated carboxylic compound, and a number average molecular weight (Mn) of 500 to 500,000.

The norbornene addition polymer may have repeating units derived from a vinyl compound in addition to the repeating units [A].

According to the present invention, there is also provided a process for producing a modified thermoplastic norbornene polymer, the process comprising addition-polymerizing a norbornene monomer represented by the formula (a1):

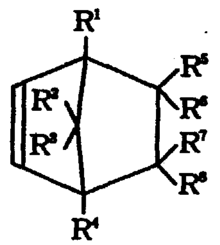

(a1)

wherein the respective meanings of the reference characters are as defined in the formula (A1), in the presence of a polymerization catalyst comprising a compound of a transition metal belonging to Group VIII of the periodic table as a main component, and then reacting the resultant norbornene addition polymer with at least one unsaturated compound selected from the group consisting of unsaturated epoxy compounds and unsaturated carboxylic compounds in the presence of an organic peroxide, thereby graft-modifying the addition polymer.

According to the present invention, there is further provided a crosslinking polymer composition comprising the above modified thermoplastic norbornene polymer and a crosslinking agent.

〈BEST MODE FOR CARRYING OUT THE INVENTION〉

Epoxy group-containing norbornene polymer:

(1) Norbornene polymer:

The norbornene polymers useful in the practice of the present invention have repeating units [A] represented by the formula (A1).

In the formula (A1), the respective meanings of the reference characters are as follows:

$R^1$ to $R^8$ are independently a hydrogen atom, hydrocarbon group, halogen atom, alkoxy group, ester group, cyano group, amide group, imide group, silyl group or hydrocarbon group substituted by a polar group (i.e., a halogen atom, alkoxy group, ester group, cyano group, amide group, imide group or silyl group). When high moisture resistance is required of the polymer, each of these groups is a hydrogen atom or hydrocarbon group.

However, at least two of $R^5$ to $R^8$ may be bonded to each other to form a monocycle or polycycle, and the monocycle or polycycle may have carbon-carbon double bond(s) or be in the form of an aromatic ring. $R^5$ and $R^6$, or $R^7$ and $R^8$ may form an alkylidene group. It goes without saying that the monocycle, polycycle or aromatic ring may have such a substituent group (hydrocarbon group, polar group or hydrocarbon group substituted by the polar group) as described above.

Examples of the halogen atom in the formula (A1) include fluorine, chlorine, bromine and iodine atoms. Examples of the hydrocarbon group include alkyl groups having 1 to 20 carbon atoms, preferably 1 to 10 carbon atoms, more preferably 1 to 6 carbon atoms, alkenyl groups having 2 to 20 carbon atoms, preferably 2 to 10 carbon atoms, more preferably 2 to 6 carbon atoms, cycloalkyl groups having 3 to 15 carbon atoms, preferably 3 to 8 carbon atoms, more preferably 5 or 6 carbon atoms, and aryl groups having 6 to 12 carbon atoms, preferably 6 to 8 carbon atoms, more preferably 6 carbon atoms. Examples of the hydrocarbon group substituted by a polar group include halogenated alkyl groups having 1 to 20 carbon atoms, preferably 1 to 10 carbon atoms, more preferably 1 to 6 carbon atoms.

Specific examples of the alkyl groups include methyl, ethyl, n-propyl, isopropyl, n-butyl, t-butyl, n-amyl, n-hexyl and decyl groups. Specific examples of the alkenyl groups include vinyl, propenyl, butenyl, pentenyl and hexenyl groups. Specific examples of the aromatic groups include phenyl, tolyl, xylyl, biphenyl and naphthyl groups.

The alkylidene group in the formula (A1) is preferably not substituted by any polar group, since the moisture resistance of the polymer is highly enhanced. The number of carbon atoms thereof is generally within a range of 1 to 20, preferably 1 to 10, more preferably 1 to 6. Specific examples of the alkylidene group include methylidene, ethylidene, propylidene and isopropylidene groups.

As preferable examples of the repeating unit [A], may be mentioned repeating units represented by the formula (A2):

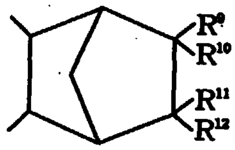

(A2)

In the formula (A2), $R^9$ to $R^{12}$ are independently a hydrogen atom, alkyl group, alkenyl group or aryl group, and generally a hydrogen atom or alkyl group. The number of carbon atoms in the alkyl group is suitably selected according to the purpose, but is generally within a range of 1 to 6, preferably 1 to 4, more preferably 1 to 3. Preferable examples of the alkyl group include methyl, ethyl, n-propyl and isopropyl groups. The number of carbon atoms in the alkenyl group is suitably selected according to the purpose, but is generally within a range of 2 to 6, preferably 2 to 4, more preferably 2 to 3. Preferable examples of the alkenyl group include vinyl and propenyl groups. The number of carbon atoms in the aryl group is suitably selected according to the purpose, but is generally within a range of 6 to 12, preferably 6 to 10, more preferably 6 to 8. Preferable examples of the aryl group include phenyl and tolyl groups.

In the formula (A2), $R^9$ and $R^{10}$, or $R^{11}$ and $R^{12}$ may form a lower alkylidene group. The number of carbon atoms in the lower alkylidene group is suitably selected as necessary for the end application intended, but is generally within a range of 1 to 6, preferably 1 to 4, more preferably 1 to 3. Preferable examples of the lower alkylidene group include methylidene, ethylidene, propylidene and isopropylidene groups.

As other preferable examples of the repeating unit [A], may be mentioned repeating units represented by the formula (A3):

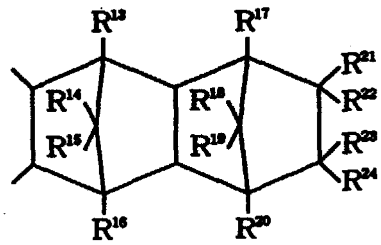

(A3)

In the formula (A3), $R^{13}$ to $R^{24}$ are independently a hydrogen atom, hydrocarbon group, halogen atom, alkoxy group, ester group (for example, alkyl ester group), cyano group, amide group, imide group, silyl group or hydrocarbon group substituted by a polar group (i.e., a halogen atom, alkoxy group, ester group, cyano group, amide group, imide group or silyl group). When high moisture resistance is required of the polymer, each of these groups is a hydrogen atom or hydrocarbon group.

However, at least two of $R^{21}$ to $R^{24}$ may be bonded to each other to form a monocycle or polycycle, and the monocycle or polycycle may have carbon-carbon double bond(s) or be in the form of an aromatic ring. $R^{21}$ and $R^{22}$, or $R^{23}$ and $R^{24}$ may form an alkylidene group. The monocycle, polycycle or aromatic ring may have such a substituent group (hydrocarbon group, polar group or hydrocarbon group substituted by the polar group) as described above. However, the substituent group is preferably a hydrocarbon group when high moisture resistance is required of the polymer.

Examples of the halogen atom in the formula (A3) include fluorine, chlorine, bromine and iodine atoms. Examples of the hydrocarbon group include alkyl groups having 1 to 20 carbon atoms, preferably 1 to 10 carbon atoms, more preferably 1 to 6 carbon atoms, alkenyl groups having 2 to 20 carbon atoms, preferably 2 to 10 carbon atoms, more preferably 2 to 6 carbon atoms, cycloalkyl groups having 3 to 15 carbon atoms, preferably 3 to 8 carbon atoms, more preferably 5 or 6 carbon atoms, and aryl groups having 6 to 12 carbon atoms, preferably 6 to 8 carbon atoms, more preferably 6 carbon atoms. Examples of the hydrocarbon group substituted by a polar group include halogenated alkyl groups having 1 to 20 carbon atoms, preferably 1 to 10 carbon atoms, more preferably 1 to 6 carbon atoms.

The alkylidene group in the formula (A3) is preferably not substituted by any polar group, since the moisture resistance of the polymer is highly enhanced. The number of carbon atoms thereof is generally within a range of 1 to 20, preferably 1 to 10, more preferably 1 to 6.

As further preferable examples of the repeating unit [A], may be mentioned repeating units represented by the formula (A4):

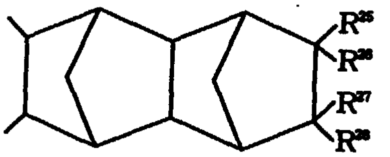

(A4)

In the formula (A4), $R^{25}$ to $R^{28}$ are independently a hydrogen atom, alkyl group, alkenyl group or aryl group, and generally a hydrogen atom or lower alkyl group. The number of carbon atoms in the alkyl group is suitably selected according to the purpose, but is generally within a range of 1 to 6, preferably 1 to 4, more preferably 1 to 3. Preferable examples of the alkyl group include methyl, ethyl, n-propyl and isopropyl groups. The number of carbon atoms in the alkenyl group is suitably selected according to the purpose, but is generally within a range of 2 to 6, preferably 2 to 4, more preferably 2 to 3. Preferable examples of the alkenyl group include vinyl and propenyl groups. The number of carbon atoms in the aryl group is suitably selected according to the purpose, but is generally within a range of 6 to 12, preferably 6 to 10, more preferably 6 to 8. Preferable examples of the aryl group include phenyl and tolyl groups.

In the formula (A4), $R^{25}$ and $R^{26}$, or $R^{27}$ and $R^{28}$ may form an alkylidene group. The number of carbon atoms in the alkylidene group is suitably selected as necessary for the end application intended, but is generally within a range of 1 to 6, preferably 1 to 4, more preferably 1 to 3. Preferable examples of the alkylidene group include methylidene, ethylidene, propylidene and isopropylidene groups.

As still further preferable examples of the repeating unit [A], may be mentioned repeating units represented by the formula (A5):

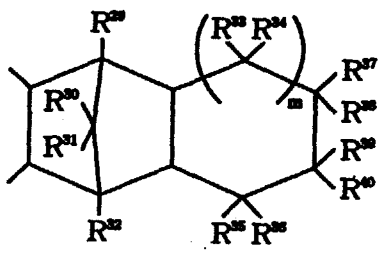

(A5)

In the formula (A5), m is 0, 1 or 2. When m is 0, a cyclopentane ring is formed.

In the formula (A5), $R^{29}$ to $R^{40}$ are independently a hydrogen atom, hydrocarbon group, halogen atom, alkoxy group, ester group (for example, alkyl ester group), cyano group, amide group, imide group, silyl group or hydrocarbon group substituted by a polar group (i.e., a halogen atom, alkoxy group, ester group, cyano group, amide group, imide group or silyl group). When high moisture resistance is required of the polymer, each of these groups is a hydrogen atom or hydrocarbon group.

However, at least two of $R^{37}$ to $R^{40}$ may be bonded to each other to form a monocycle or polycycle, and the monocycle or polycycle may have carbon-carbon double bond(s) or be in the form of an aromatic ring. $R^{37}$ and $R^{38}$, or $R^{39}$ and $R^{40}$ may form an alkylidene group, or $R^{38}$ and $R^{39}$ may be bonded to each other to form a double bond between 2 carbon atoms to which $R^{38}$ and $R^{39}$ are bonded, respectively. It goes without saying that the monocycle, polycycle or aromatic ring may have such a substituent group (hydrocarbon group, polar group or hydrocarbon group substituted by the polar group) as described above.

Examples of the halogen atom in the formula (A5) include fluorine, chlorine, bromine and iodine atoms. Examples of the hydrocarbon group include alkyl groups having 1 to 20 carbon atoms, preferably 1 to 10 carbon atoms, more preferably 1 to 6 carbon atoms, alkenyl groups having 2 to 20 carbon atoms, preferably 2 to 10 carbon atoms, more preferably 2 to 6 carbon atoms, cycloalkyl groups having 3 to 15 carbon atoms, preferably 3 to 8 carbon atoms, more preferably 5 or 6 carbon atoms, and aryl groups having 6 to 12 carbon atoms, preferably 6 to 8 carbon atoms, more preferably 6 carbon atoms. Examples of the hydrocarbon group substituted by a polar group include halogenated alkyl groups having 1 to 20 carbon atoms, preferably 1 to 10 carbon atoms, more preferably 1 to 6 carbon atoms.

The alkylidene group in the formula (A5) is preferably not substituted by any polar group, since the moisture resistance of the polymer is highly enhanced. The number of carbon atoms thereof is generally within a range of 1 to 20, preferably 1 to 10, more preferably 1 to 6.

As yet still further preferable examples of the repeating unit [A], may be mentioned repeating units represented by the formula (A6):

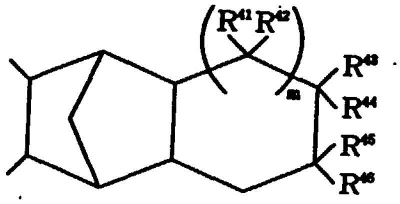

(A6)

In the formula (A6), m is 0, 1 or 2. When m is 0, a cyclopentane ring is formed.

In the formula (A6), $R^{41}$ to $R^{46}$ are independently a hydrogen atom, lower alkyl group, lower alkenyl group or aryl group, and generally a hydrogen atom or alkyl group. The number of carbon atoms in the alkyl group is suitably selected according to the purpose, but is generally within a range of 1 to 6, preferably 1 to 4, more preferably 1 to 3. Preferable examples of the alkyl group include methyl, ethyl, n-propyl and isopropyl groups. The number of carbon atoms in the alkenyl group is suitably selected according to the purpose, but is generally within a range of 2 to 6, preferably 2 to 4, more preferably 2 to 3. Preferable examples of the alkenyl group include vinyl and propenyl groups. The number of carbon atoms in the aryl group is suitably selected according to the purpose, but is generally within a range of 6 to 12, preferably 6 to 10, more preferably 6 to 8. Preferable examples of the aryl group include phenyl and tolyl groups.

Further, at least two of $R^{43}$ to $R^{46}$ may be bonded to each other to form a monocycle, polycycle or aromatic ring, or $R^{43}$ and $R^{44}$, or $R^{45}$ and $R^{46}$ may form an alkylidene group, or $R^{44}$ and $R^{45}$ may be bonded to each other to form a double bond between 2 carbon atoms to which $R^{44}$ and $R^{45}$ are bonded, respectively. Of these, it is preferred that at least two of $R^{43}$ to $R^{46}$ should be bonded to each other to form an aromatic ring, or $R^{44}$ and $R^{45}$ should be bonded to each other to form a carbon-carbon double bond. The aromatic ring is generally a benzene ring which may be substituted by a lower alkyl group having 1 to 6 carbon atoms. The number of carbon atoms in the lower alkylidene group is suitably selected as necessary for the end application intended, but is generally within a range of 1 to 6, preferably 1 to 4, more preferably 1 to 3. Preferable examples of the lower alkylidene group include methylidene, ethylidene, propylidene and isopropylidene groups.

The repeating units [A] represented by these formulae (A1) to (A6) may be used either singly or in any combination thereof. Norbornene addition polymers having the repeating units of (A2), (A4) and (A6), respectively, are preferred.

The norbornene addition polymers used in the present invention can provide modified thermoplastic norbornene polymers having particularly high heat resistance when they have only the repeating units [A] derived from a norbornene monomer.

The norbornene addition polymers used in the present invention may have the repeating units [A] derived from the norbornene monomer and repeating units derived from a vinyl compound. In this case, the content of the bound norbornene monomer is suitably selected as necessary for the end application intended. However, it is generally at least 30 wt.%, preferably at least 50 wt.%, more preferably at least 70 wt.%. Even when an addition copolymer of a norbornene monomer and a vinyl compound is used, excellent heat resistance can be exhibited by crosslinking when using the resulting modified thermoplastic norbornene polymer in combination with a crosslinking agent.

(2) Production process:

The norbornene polymers having the repeating units [A] can be obtained by addition-polymerizing a norbornene monomer represented by the formula (a1):

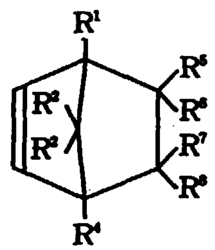

(a1)

wherein the respective meanings of the reference characters are as defined in the formula (A1).

(Norbornene monomer)

Of the norbornene monomers represented by the formula (a1), compounds represented by the formula (a2):

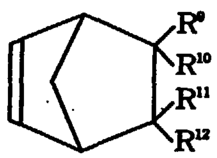

(a2)

wherein the respective meanings of the reference characters are as defined in the formula (A2), compounds represented by the formula (a3):

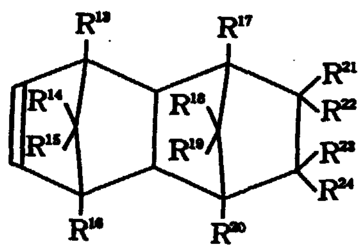

(a3)

wherein the respective meanings of the reference characters are as defined in the formula (A3), compounds represented by the formula (a4):

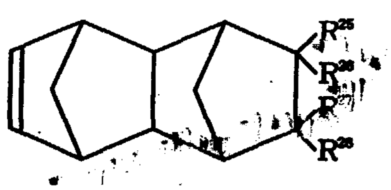

(a4)

wherein the respective meanings of the reference characters are as defined in the formula (A4), compounds represented by the formula (a5):

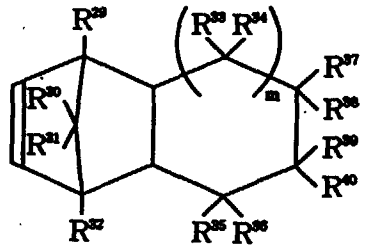

(a5)

wherein the respective meanings of the reference characters are as defined in the formula (A5), and compounds represented by the formula (a6):

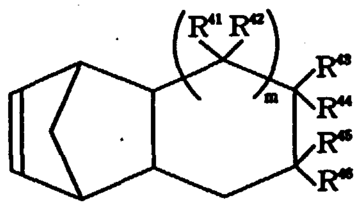

(a6)

wherein the respective meanings of the reference characters are as defined in the formula (A6), are preferably used. Of these compounds, the norbornene monomers represented by the formulae (a2), (a4) and (a6) are particularly preferred.

As specific examples of such norbornene monomers, there may be used publicly known monomers disclosed in Japanese Patent Application Laid-Open Nos. 227424/1990, 276842/1990, 97719/1993, 41550/1995 and 72210/1996, etc. Specifically, the following norbornene monomers may be mentioned.

Examples of the norbornene monomers include bicyclo[2.2.1]hept-2-ene derivatives, tetracyclo[4.4.0.$1^{2,5}$.$1^{7,10}$]-3-dodecene derivatives, hexacyclo[6.6.1.$1^{3,6}$.$1^{10,13}$.$0^{2,7}$.$0^{9,14}$]-4-heptadecene derivatives, octacyclo[8.8.0.$1^{2,9}$.$1^{4,7}$.$1^{11,18}$.$1^{13,16}$.$0^{3,8}$.$0^{12,17}$]-5-docosene derivatives, pentacyclo[6.6.1.$1^{3,6}$.$0^{2,7}0^{9,14}$]-4-hexadecene derivatives, heptacyclo-5-eicosene derivatives; heptacyclo-5-heneicosene derivatives, tricyclo[4.3.0.$1^{2,5}$]-3-decene derivatives, tricyclo[4.4.0.$1^{2,5}$]-3-undecene derivatives, pentacyclo[6.5.1.$1^{3,6}$.$0^{2,7}$.$0^{9,13}$]-4-pentadecene derivatives, pentacyclopentadecadiene derivatives, pentacyclo[7.4.0.$1^{2,5}$.$1^{9,12}$.$0^{8,13}$]-3-pentadecene derivatives, heptacyclo[8.7.0.$1^{3,6}$.$1^{10,17}$.$1^{12,15}$.$0^{2,7}$.$0^{11,16}$]-4-eicosene derivatives, nonacyclo[10.9.1.$1^{4,7}$.$1^{13,20}$.$1^{15,18}$.$0^{3,8}$.$0^{2,10}$.$0^{12,21}$.$0^{14,19}$]-5-pentacosene derivatives, pentacyclo[8.4.0.$1^{2,5}$.$1^{9,12}$. $0^{8,13}$]-3-hexadecene derivatives, heptacyclo[8.8.0.$1^{4,7}$.$1^{11,18}$. $1^{13,16}$.$0^{3,8}$.$0^{12,17}$]-5-heneicosene derivatives, nonacyclo[10.10.1.$1^{5,8}$.$1^{14,21}$.$1^{16,19}$.$0^{2,11}$.$0^{4,9}$.$0^{13,22}$.$0^{15,20}$]-5-hexacosene derivatives, 1,4-methano-1,4,4a,9a-tetrahydrofluorene derivatives, 1,4-methano-1,4,4a,5,10,10a-hexahydroanthracene derivatives and cyclopentadiene-acenaphthylene adducts.

More specifically, examples of the norbornene monomers include bicyclo[2.2.1]hept-2-ene derivatives such as bicyclo[2.2.1]hept-2-ene, 6-methylbicyclo[2.2.1]hept-2-ene, 5,6-dimethylbicyclo[2.2.1]hept-2-ene, 1-methylbicyclo[2.2.1]hept-2-ene, 6-ethylbicyclo[2.2.1]hept-2-ene, 6-n-butylbicyclo[2.2.1]hept-2-ene, 6-isobutylbicyclo[2.2.1]hept-2-ene and 7-methylbicyclo[2.2.1]hept-2-ene; tetracyclo[4.4.0.$1^{2,5}$.$1^{7,10}$]-3-dodecene derivatives such as tetracyclo[4.4.0.$1^{2,5}$.$1^{7,10}$]-3-dodecene, 8-methyltetracyclo[4.4.0.$1^{2,5}$.$1^{7,10}$]-3-dodecene, 8-ethyltetracyclo[4.4.0.$1^{2,5}$. $1^{7,10}$]-3-dodecene, 8-propyltetracyclo[4.4.0.$1^{2,5}$.$1^{7,10}$]-3-dodecene, 8-butyltetracyclo[4.4.0.$1^{2,5}$.$1^{7,10}$]-3-dodecene, 8-isobutyltetracyclo[4.4.0.$1^{2,5}$.$1^{7,10}$]-3-dodecene, 8-hexyltetracyclo[4.4.0.$1^{2,5}$.$1^{7,10}$]-3-dodecene, 8-cyclohexyltetracyclo[4.4.0.$1^{2,5}$.$1^{7,10}$]-3-dodecene, 8-stearyltetracyclo[4.4.0.$1^{2,5}$.$1^{7,10}$]-3-dodecene, 5,10-dimethyltetracyclo[4.4.0.$1^{2,5}$.$1^{7,10}$]-3-dodecene, 2,10-dimethyltetracyclo[4.4.0.$1^{2,5}$.$1^{7,10}$]-3-dodecene, 8,9-dimethyltetracyclo[4.4.0.$1^{2,5}$.$1^{7,10}$]-3-dodecene, 8-ethyl-9-methyltetracyclo[4.4.0.$1^{2,5}$.$1^{7,10}$]-3-dodecene, 11,12-dimethyltetracyclo[4.4.0.$1^{2,5}$.$1^{7,10}$]-3-dodecene, 2,7,9-trimethyltetracyclo[4.4.0.$1^{2,5}$.$1^{7,10}$]-3-dodocene, 9-ethyl-2,7-dimethyltetracyclo[4.4.0;$1^{2,5}$.$1^{7,10}$]-3-dodecene, 9-isobutyl-2,7-dimethyltetracyclo[4.4.0.$1^{2,5}$.$1^{7,10}$]-3-dodecene, 9,11,12-trimethyltetracyclo[4.4.0.$1^{2,5}$.$1^{7,10}$]-3-dodecene, 9-ethyl-11,12-dimethyltetracyclo[4.4.0,$1^{2,5}$.$1^{7,10}$]-3-dodecene, 9-isobutyl-11,12-dimethyltetracyclo[4.4.0.$1^{2,5}$.$1^{7,10}$]-3 dodecene, 5,8,9,10-tetramethyltetracyclo[4.4.0.$1^{2,5}$.$1^{7,10}$]-3-dodecene, 8-ethylidene-9-methyltetracyclo[4.4.0.$1^{2,5}$.$1^{7,10}$]-3-dodecene, 8-ethylidene-9-ethyltetracyclo[4.4.0.$1^{2,5}$.$1^{7,10}$]-3-dodecene, 8-ethylidene-9-isopropyltetracyclo[4.4.0.$1^{2,5}$.$1^{7,10}$]-3-dodecene, 8-ethylidene-9-butyltetracyclo[4.4.0.$1^{2,5}$.$1^{7,10}$]-3-dodecene, 8-n-propylidenetetracyclo[4.4.0.$1^{2,5}$.$1^{7,10}$]-3-dodecene, 8-n-propylidene-9-methyltetracyclo[4.4.0.$1^{2,5}$.$1^{7,10}$]-3-dodecene, 8-n-propylidene-9-ethyltetracyclo[4.4.0.$1^{2,5}$.$1^{7,10}$]-3-dodecene, 8-n-propylidene-9-isopropyltetracyclo[4.4.0.$1^{2,5}$.$1^{7,10}$]-3-dodecene, 8-n-propylidene-9-butyltetracyclo[4.4.0.$1^{2,5}$. $1^{7,10}$]-3-dodecene, 8-isopropylidenetetracyclo[4.4.0.$1^{2,5}$. $1^{7,10}$]-3-dodecene, 8-isopropylidene-9-methyltetracyclo[4.4.0.$1^{2,5}$.$1^{7,10}$]-3-dodecene, 8-isopropylidene-9-ethyltetracyclo[4.4.0.$1^{2,5}$.$1^{7,10}$]-3-dodecene, 8-isopropylidene-9-isopropyltetracyclo[4.4.0.$1^{2,5}$.$1^{7,10}$]-3-dodecene, 8-isopropylidene-9-butyltetracyclo[4 4.0.$1^{2,5}$.$1^{7,10}$]-3-dodecene, 8-chlorotetracyclo[4.4.0.$1^{2,5}$.$1^{7,10}$]-3-dodecene, 8-bromotatracyclo[4.4.0.$1^{2,5}$.$1^{7,10}$]-3-dodecene, 8-fluorotetracyclo[4.4.0.$1^{2,5}$.$1^{7,10}$]-3-dodecene and 8,9-dichlorotetracyclo[4.4.0.$1^{2,5}$.$1^{7,10}$]-3-dodecene; hexacyclo[6.6.1.$1^{3,6}$.$1^{10,13}$.$0^{2,7}$. $0^{9,14}$]-4-heptadecene derivatives such as hexacyclo[6.6.1.$1^{3,6}$.$1^{10,13}$.$0^{2,7}$.$0^{9,14}$]-4-heptadecene, 12-methylhexacyclo[6.6.1.$1^{3,6}$.$1^{10,13}$.$0^{2,7}$.$0^{9,14}$]-4-heptadecene, 12-ethylhexacyclo[6.6.1.$1^{3,6}$.$1^{10,13}$.$0^{2,7}$.$0^{9,14}$]-4-heptadecene, 12-isobutylhexacyclo[6.6.1.$1^{3,6}$.$1^{10,13}$.$0^{2,7}$.$0^{9,14}$]-4-heptadecene and 1.6,10-trimethyl-12-isobutylhexacyclo[6.6.1.$1^{3,6}$.$1^{10,13}$.$0^{2,7}$.$0^{9,14}$]-4-heptadecene; octacyclo[8.8.0.$1^{2,9}$.$1^{4,7}$.$1^{11,18}$.$1^{13,16}$.$0^{3,8}$.$0^{12,17}$]-5-docosene derivatives such as octacyclo[8.8.0.$1^{2,9}$.$1^{4,7}$.$1^{11,18}$.$1^{13,16}$.$0^{3,8}$.$0^{12,17}$]-5-docosene, 15-methyloctacyclo[8.8.0.$1^{2,9}$.$1^{4,7}$.$1^{11,18}$.$1^{13,16}$.$0^{3,8}$. $0^{12,17}$]-5-docosene and 15-ethyloctacyclo[8.8.0.$1^{2,9}$.$1^{4,7}$.$1^{11,18}$. $1^{13,16}$.$0^{3,8}$.$0^{12,17}$]-5-docosene; pentacyclo[6.6.1.$1^{3,6}$.$0^{2,}$7$0^{9,14}$]-4-hexadecene derivatives such as pentacyclo[6.6.1.$1^{3,6}$.$0^{2,7}$$0^{9,14}$]-4-hexadecene, 1,3-dimethylpentacyclo[6.6.1.$1^{3,6}$.$0^{2,7}$$0^{9,14}$]-4-hexadecene, 1,6-dimethylpentacyclo[6.6.1.$1^{3,6}$.$0^{2,7}$$0^{9,14}$]-4-hexadecene and 15,16-dimethylpentacyclo[6.6.1.$1^{3,6}$.$0^{2,7}$$0^{9,14}$]-4-hexadecone; heptacyclo-5-eicosene derivatives or heptacyclo-5-heneicosene derivatives such as heptacyclo[8.7.0.$1^{2,9}$.$1^{4,7}$.$1^{11,17}$.$0^{3,8}$. $0^{12,16}$]-5-eicosene and heptacyclo[8.8.0.$1^{2,9}$.$1^{4,7}$.$1^{11,18}$.$0^{3,8}$. $0^{12,17}$]-5-heneicosene; tricyclo[4.3.0.$1^{2,5}$]-3-decene derivatives such as tricyclo[4.3.0.$1^{2,5}$]-3-decene, 2-methyltricyclo[4.3.0.$1^{2,5}$]-3-decene and 5-methyltricyclo[4.3.0.$1^{2,5}$]-3-decene; tricyclo[4.3.0.$1^{2,5}$]-3-undecene derivatives such as tricyclo[4.3.0.$1^{2,5}$]-3-undecene and 10-methyltricyclo[4.3.0.$1^{2,5}$]-3-undecene; pentacyclo[6.5.1.$1^{3,6}$.$0^{2,7}$.$0^{9,13}$]-4-pentadecene derivatives such as pentacyclo[6.5.1.$1^{3,6}$.$0^{2,7}$.$0^{9,13}$]-4-pentadecene, 1,3-dimethylpentacyclo[6.5.1.$1^{3,6}$.$0^{2,7}$.$0^{9,13}$]-4-pentadecene, 1,6-dimethylpentacyclo[6.5.1.$1^{3,6}$.$0^{2,7}$.$0^{9,13}$]-4-pentadecene and 14,15-dimethylpentacyclo[6.5.1.$1^{3,6}$.$0^{2,7}$.$0^{9,13}$]-4-pentadecene; diene compounds such as pentacyclo[6.5.1.$1^{3,6}$.$0^{2,7}$.$0^{9,13}$]-4,10-pentadecadiene; pentacyclo[7.4.0.$1^{2,5}$.$1^{9,12}$.$0^{8,13}$]-3-pentadecene derivatives such as pentacyclo[7.4.0.$1^{2,5}$.$1^{9,12}$.$0^{8,13}$]-3-pentadecene and methyl-substituted pentacyclo[7.4.0.$1^{2,5}$.$1^{9,12}$.$0^{8,13}$]-3-pentadecene; heptacyclo[8.7.0.$1^{3,6}$.$1^{10,17}$.$1^{12,15}$.$0^{2,7}$.$0^{11,16}$]-4-eicosene derivatives such as heptacyclo[8.7.0.$1^{3,6}$.$1^{10,17}$.$1^{12,15}$.$0^{2,7}$.$0^{11,16}$]-4-eicosene and dimethyl-substituted heptacyclo[8.7.0.$1^{3,6}$.$1^{10,17}$.$1^{12,15}$.$0^{2,7}$.$0^{11,16}$]-4-eicosene; nonacyclo[10.9.1.$1^{4,7}$.$1^{13,20}$.$1^{15,18}$.$0^{3,8}$.$0^{2,10}$.$0^{12,21}$.$0^{14,19}$]-5-pentacosene derivatives such as nonacyclo[10.9.1.$1^{4,7}$.$1^{13,20}$.$1^{15,18}$.$0^{3,8}$. $0^{2,10}$.$0^{12,21}$.$0^{14,19}$]-5-pentacosene and trimethyl-substituted nonacyclo[10.9.1.$1^{4,7}$.$1^{13,20}$.$1^{15,18}$.$0^{3,8}$.$0^{2,10}$.$0^{12,21}$.$0^{14,19}$]-5-pentacosene; pentacyclo[8.4.0.$1^{2,5}$.$1^{9,12}$.$0^{8,13}$]-3-hexadecene derivatives such as pentacyclo[8.4.0.$1^{2,5}$.$1^{9,12}$.$0^{8,13}$]-3-hexadocene, 11-methylpentacyclo[8.4.0.$1^{2,5}$.$1^{9,12}$.$0^{8,13}$]-3-hexadecene, 11-ethylpentacyclo[8.4.0.$1^{2,5}$.$1^{9,12}$.$0^{8,13}$]-3-hexadecene and 10,11-dimethylpentacyclo[8.4.0.$1^{2,5}$.$1^{9,12}$. $0^{8,13}$]-3-hexadecene; heptacyclo[8.8.0.$1^{4,7}$.$1^{11,18}$.$1^{13,16}$.$0^{3,8}$. $0^{12,17}$]-5-heneicosene derivatives such as heptacyclo[8.8.0.$1^{4,7}$.$1^{11,18}$.$1^{13,16}$.$0^{3,8}$.$0^{12,17}$]-5-heneicosene, 15-methylheptacyclo[8.8.0.$1^{4,7}$.$1^{11,18}$.$1^{13,16}$.$0^{3,8}$.$0^{12,17}$]-5-heneicosene and trimethylheptacyclo[8.8.0.$1^{4,7}$.$1^{11,18}$.$1^{13,16}$.$0^{3,8}$.$0^{12,17}$]-5-heneicosene; nonacyclo[10.10.1.$1^{5,8}$.$1^{14,21}$.$1^{16,19}$.$0^{2,11}$.$0^{4,9}$. $0^{13,22}$.$0^{15,20}$]-6-hexacosene derivatives such as nonacyclo[10.10.1.$1^{5,8}$.$1^{14,21}$.$1^{16,19}$.$0^{2,11}$.$0^{4,9}$.$0^{13,22}$.$0^{15,2}$0]-6-hexacosene; pentacyclo[6.5.1.$1^{3,6}$.$0^{2,7}$.$0^{9,13}$]-4,11-pentndecodiene, methyl-substituted pentacyclo[6.5.1.$1^{3,6}$.$0^{2,7}$.$0^{9,13}$]-4,11-pentadecadiene, trimethyl-substituted pentacyclo[4.7.0.$1^{2,5}$. $0^{8,13}$.$1^{9,12}$]-3-pentadecene, pentacyclo[4.7.0.$1^{2,5}$.$0^{8,13}$.$1^{9,12}$]-3,10-pentadecadiene, methyl-substituted pentacyclo[4.7.0.$1^{2,5}$.$0^{8,13}$.$1^{9,12}$]-3,10-pentadecadiene, methyl-substituted heptacyclo[7.8.0.$1^{3,6}$.$0^{2,7}$.$1^{10,17}$.$0^{11,16}$.$1^{12,15}$]-4-eicosene, trimethyl-substituted heptacyclo[7.8.0.$1^{3,6}$.$0^{2,7}$. $1^{10,17}$.$0^{11,16}$.$1^{12,15}$]-4-eicosene, tetramethyl-substituted heptacyclo[7.8.0.$1^{3,6}$.$0^{2,7}$.$1^{10,17}$.$0^{11,16}$.$1^{12,15}$]-4-eicosene, tricyclo[4.3.0.$1^{2,5}$]-3,7-decadiene (i.e., dicyclopentadiene), 2,3-dihydrodicyclopentodiene, 5-phenylbicyclo[2.2.1]hept-2-ene (i.e.. 5-phenyl-2-norbornene), 5-methyl-5-phenylbicyclo[2.2.1]hept-2-ene, 5-benzyl-bicyclo[2.2.1]hept-2-ene, 5-tolylbicyclo[2.2.1]hept-2-ene, 5-(ethylphenyl)-bicyclo[2.2.1]hept-2-ene, 5-(isopropylphenyl)-bicyclo[2.2.1]hept-2-ene, 8-phenyl-tetracyclo[4.4.0.$1^{2,5}$.$1^{7,10}$]-3-dodecene, 8-methyl-8-phenyl-tetracyclo[4.4.0.$1^{2,5}$.$1^{7,10}$]-3 dodecene, 8-benzyl-tetracyclo[4.4.0.$1^{2,5}$.$1^{7,10}$]-3-dodecene, 8-tolyl-tetracyclo[4.4.0.$1^{2,5}$.$1^{7,10}$]-3-dodecene, 8-(ethylphenyl)-tetracyclo[4.4.0.$1^{2,5}$.$1^{7,10}$]-3-dodecene, 8-(isopropylphenyl)-tetracyclo[4.4.0.$1^{2,5}$.$1^{7,10}$]-3-dodecene, 8,9-diphenyl-tetracyclo[4.4.0.$1^{2,5}$.$1^{7,10}$]-3-dodecene, 8-(biphenyl)-tetracyclo[4.4.0.$1^{2,5}$.$1^{7,10}$]-3-dodecene, 8-(β-naphthyl)-tetracyclo[4.4.0.$1^{2,5}$.$1^{7,10}$]-3-dodecene, 8-(α-naphthyl)-tetracyclo[4.4.0.$1^{2,5}$.$1^{7,10}$]-3-dodecene, 8-(anthracenyl)-tetracyclo[4.4.0.$1^{2,5}$.$1^{7,10}$]-3-dodecene, 11-phenyl-hexacyclo[6.6.1.$1^{3,6}$.$0^{2,7}$$0^{9,14}$]-4-heptadecene, 6-(α-naphthyl)-bicyclo[2.2.1]-hept-2-ene, 5-(anthracenyl)-bicyclo[2.2.1]hept-2-ene, 5-(biphenyl)-bicyclo[2.2.1]-hept-2-ene, 5-(β-naphthyl)-bicyclo[2.2.1]hept-2-ene, 5,6-diphenyl-bicyclo[2.2.1]hept-2-ene, 9-(2-norbornen-5-yl)carbazole, 1,4-methano-1,4,4a,4b,5,8,8a,9a-octahydrofluorene and derivatives thereof; 1,4-methano-1,4,4a,9a-tetrahydrofluorene and derivatives thereof, such as 1,4-methano-1,4,4a,9a-tetrahydrofluorene, 1,4-methano-8-methyl-1,4,4a,9a-tetrahydrofluorene, 1,4-methano-8-chloro-1,4,4a,9a-tetrahydrofluorene and 1,4-methano-8-bromo-1,4,4a,9a-tetrahydrofluorene; 1,4-methano-1,4,4a,9a-tetrahydrobenzofuran and derivatives thereof; 1,4-methano-1,4,4a,9a-tetrahydrocarbazole and derivatives thereof, such as 1,4-methano-1,4,4a,9a-tetrahydrocarbazole and 1,4-methano-9-phenyl-1,4,4a,9a-tetrahydrocarbazole; 1,4-methano-1,4,4a,5,10,10a-hexahydroanthracene and derivatives thereof, such as 1,4-methano-1,4,4a,5,10,10a-hexahydroanthracene; 7,10-methano-6b,7,10,10a-tetrahydrofluoracene and derivatives thereof; and compounds obtained by further adding cyclopentadiene to cyclopentadieneacenaphthylene adducts, 11,12-benzo-pentacyclo[6.5.1.$1^{3,6}$. $0^{2,7}$.$0^{9,13}$]-4-pentadecene, 11,12-benzo-pentacyclo[6.6.1.$1^{3,6}$. $0^{2,7}$.$0^{9,14}$]-4-hexadecene, 14,15-benzo-heptacyclo[8.7.0.$1^{2,9}$. $1^{4,7}$.$1^{11,17}$.$0^{3,8}$.$0^{12,16}$]-5-eicosene, and cyclopentadieneacenaphthylene adducts.

These norbornene monomers may be used either singly or in any combination thereof.

(Vinyl compound)

Examples of copolymerizable vinyl compounds include ethylenes or $\alpha$-olefins having 2 to 20 carbon atoms, such as ethylene, propylene, 1-butene, 1-pentene, 1-hexene, 3-methyl-1-butene, 3-methyl-1-pentene, 3-ethyl-1-pentene, 4-methyl-1-pentene, 4-methyl-1-hexene, 4,4-dimethyl-1-hexene, 4,4-dimethyl-1-pentene, 4-ethyl-1-hexene, 3-ethyl-1-hexene, 1-octene, 1-decene, 1-dodecene, 1-tetradecene, 1-hexadecene, 1-octadecene and 1-eicosene; cycloolefins such as cyclobutene, cyclopentene, cyclohexene, 3,4-dimethylcyclopentene, 3-methylcyclohexene, 2-(2-methylbutyl)-1-cyclohexene, cyclooctene and 3a,5,6,7a-tetrahydro-4,7-methano-1H-indene; and non-conjugated dienes such as 1,4-hexadiene, 4-methyl-1,4-hexadiene, 5-methyl-1,4-hexadiene and 1,7-octadiene. These vinyl compounds may be used either singly or in any combination thereof.

(Catalyst and polymerization process)

With respect to a catalyst and a polymerization process, polymerization may be conducted in accordance with a process known *per se* in the art. For example, the processes disclosed in, J. Organomet. Chem., 358, 576- 588 (1988), Japanese Patent Application Laid-Open Nos. 205408/1991, 63807/1992 and 262821/1993, and WO95/14048 may be used.

As a catalyst for the addition polymerization of a norbornene monomer, is used a catalyst comprising a transition metal belonging to Group VIII of the periodic table as a main component. Examples of the transition metal belonging to Group VIII of the periodic table include iron, cobalt, nickel, ruthenium, podium, palladium and platinum. Of these, cobalt, nickel and palladium are preferred. Specific examples of the catalyst comprising such a transition metal as a main component will hereinafter be mentioned.

Examples of iron compounds include iron (II) chloride, iron (III) chloride, iron (II) acetate, iron (II) acetylacetonate and ferrocene. Examples of cobalt compounds include cobalt (II) acetate, cobalt (II) acetylacetonate, cobalt (II) tetrafluoroborate, cobalt chloride and cobalt (II) benzoate. Examples of nickel compounds include nickel acetate, nickel acetylacetonate, nickel carbonate, nickel chloride, nickel ethylhexanoate, nickelocene, $NiCl_2(PPh_3)_2$ (wherein Ph is a phenyl group), bisallylnickel and nickel oxide. Examples of palladium compounds include palladium chloride, palladium bromide, palladium oxide, $PdCl_2(PPh_3)_2$, $PdCl_2(PhCN)_2$, $PdCl_2(CH_3CN)_2$, $[Pd(CH_3CN)_4][BF_4]_2$, $[Pd(C_2H_5CN)_4][BF_4]_2$, palladium acetylacetonate and palladium acetate. Of these, palladium chloride, nickel acetylacetonate, $PdCl_2(PhCN)_2$, $[Pd(CH_3CN)_4][BF_4]_2$ are particularly preferred.

These catalysts may be used either singly or in any combination thereof. The amount of the catalyst used may be suitably selected according to polymerization conditions and the like. However, it is generally 1/1,000,000 to 1/10, preferably 1/100,000 to 1/100 in terms of its molar ratio to the total amount of the norbornene monomer(s).

In the present invention, a promoter may be used as needed. For example, aluminoxane is preferably used. As the aluminoxane, methylaluminoxane is preferably used. The promotors may be used either singly or in any combination thereof. The amount of the promoter used is suitably selected according to the kind of the promoter used, and the like. When the aluminoxane is used as a promoter, the amount used is generally within a range of 1 to 100,000, preferably 5 to 10,000 in terms of a ratio (molar ratio) of aluminum in the aluminoxane to the transition metal in the catalyst, i.e., aluminum/transition metal.

The polymerization reaction may be conducted either by bulk polymerization without using any solvent or in a solvent such as an organic solvent. No particular limitation is imposed on the solvent so far as it is inert to the polymerization reaction. However, examples thereof include aromatic hydrocarbons such as benzene, toluene and xylene; aliphatic hydrocarbons such as n-pentane, hexane and heptane; alicyclic hydrocarbons such as cyclohexane; halogenated hydrocarbons such as styrene dichloride, dichloroethane. dichloroethylene, tetrachloroethane, chlorobenzene, dichlorobenzene and trichlorobenzene; and nitrogen-containing hydrocarbons such as nitromethane, nitrobenzene, acetonitrile and benzonitrile.

The polymerization temperature is generally within a range of -50°C to 250°C, preferably -30°C to 200°C, more preferably -20°C to 150°C, and the polymerization pressure is generally within a range of 0 to 50 kg/cm$^2$, preferably 0 to 20 kg/cm$^2$. The polymerization time is suitably selected according to polymerization conditions, but is generally within a range of 30 minutes to 20 hours, preferably 1 to 10 hours.

An addition copolymer of a norbornene monomer and a vinyl compound can preferably be obtained by, for example, a process comprising copolymerizing the monomer components in a hydrocarbon solvent or without using any solvent in the presence of a catalyst system composed of a vanadium compound and an organoaluminum compound, generally, at a polymerization temperature of -50°C to 100°C and a polymerization pressure of 0 to 50 kg/cm$^2$.

The molecular weight of the norbornene addition polymer used is 500 to 500,000, preferably 1,000 to 200,000, more preferably 5,000 to 100,000 when expressed by a number average molecular weight (Mn) in terms of polystyrene as measured by gel permeation chromatography (GPC) using toluene as a solvent or when expressed by a number average molecular weight (Mn) in terms of polyisoprene as measured by GPC using cyclohexane as a solvent if the polymer is insoluble in toluene.

If the number average molecular weight (Mn) of the norbornene addition polymer is extremely low, the mechanical strength of the polymer becomes poor. If the molecular weight is extremely high on the other hand, the rate of graft modification with the unsaturated compound selected from the group consisting of unsaturated epoxy compounds and unsaturated carboxylic compounds cannot be sufficiently heightened, and the processability of the resulting modified polymer is also deteriorated.

No particular limitation is imposed on the molecular weight distribution of the norbornene addition polymer. However, it is preferred that its ratio (Mw/Mn) of the weight average molecular weight (Mw) to the number average molecular weight (Mn) in terms of polystyrene as measured by GPC using toluene as a solvent be generally 4.0 or lower, preferably 3.0 or lower, more preferably 2.5 or lower, since the mechanical strength of the polymer is highly enhanced.

The glass transition temperature (Tg) of the norbornene addition polymer may be suitably selected as necessary for the end application intended. However, it is generally about 50 to 400°C as measured by a differential scanning calorimeter (DSC). The norbornene addition polymer preferably has a high glass transition temperature because a modified thermoplastic norbornene polymer having a high glass transition temperature can be obtained, deterioration of mechanical strength of the modified polymer particularly in a region of high temperatures such as a temperature upon packaging of electronic parts and the like, and a reliability testing temperature is suppressed, and its viscosity characteristics also become excellent. Even when the glass transition temperature is comparatively low, however, the heat resistance can be sufficiently enhanced by using the modified polymer in combination with a crosslinking agent to form a crosslinked polymer.

(Graft modification)

The modified thermoplastic norbornene polymers according to the present invention can be produced by reacting any of the above-described norbornene addition polymers with at least one unsaturated compound selected from the group consisting of unsaturated epoxy compounds and unsaturated carboxylic compounds in the presence of an organic peroxide.

Examples of the unsaturated epoxy compounds include glycidyl esters such as glycidyl acrylate, glycidyl methacrylate and glycidyl p-styrylcarboxylate; monoglycidyl esters or polyglycidyl esters of unsaturated polycarboxylic acids such as endo-cis-bicyclo[2,2,1]hept-5-ene-2,3-dicarboxylic acid and endo-cis-bicyclo[2,2.1]hept-5-ene-2-methyl-2,3-dicarboxylic acid; unsaturated glycidyl ethers such as allyl glycidyl ether, 2-methylallyl glycidyl ether, glycidyl ether of o-allylphenol, glycidyl ether of m-allylphenol and glycidyl ether of p-allylphenol; and 2-(o-vinylphenyl)ethylene oxide, 2-(p-vinylphenyl)ethylene oxide, 2-(o-allylphenyl)ethylene oxide, 2-(p-allylphenyl)ethylene oxide, 2-(o-vinylphenyl)propylene oxide, 2-(p-vinylphenyl)propylene oxide, 2-(o-allylphenyl)propylene oxide, 2-(p-allylphenyl)propylene oxide, p-glycidylstyrene, 3,4-epoxy-1-butene, 3,4-epoxy-3-methyl-1-butene, 3,4-epoxy-1-pentene, 3,4-epoxy-3-methyl-1-pentene, 5,6-epoxy-1-hexene, vinylcyclohexene monoxide and allyl-2,3-epoxycyclopentyl ether. Of these, the allyl glycidyl esters, allyl glycidyl ethers and epoxy group-containing $\alpha$-olefins such as 5,6-epoxy-1-hexene are preferred.

These unsaturated epoxy compounds may be used either singly or in any combination thereof.

As the unsaturated carboxylic compounds, may be used unsaturated carboxylic acids or derivatives thereof. As examples of such unsaturated carboxylic acids, may be mentioned acrylic acid, maleic acid, fumaric acid, tetrahydrophthalic acid, itaconic acid, citraconic acid, crotonic acid, isocrotonic acid and nadic acid (endo-cis-bicyclo[2,2,1]hept-5-ene-2,3-dicarboxylic acid). As examples of derivatives of the above-described unsaturated carboxylic acids, may be mentioned unsaturated carboxylic acid anhydrides, unsaturated carboxylic acid halides, unsaturated carboxylic acid amides, unsaturated carboxylic acid imides and ester compounds of the unsaturated carboxylic acids. As specific examples of such derivatives, may be mentioned malenyl chloride, maleimide, maleic anhydride, citraconic anhydride, monomethyl maleate, dimethyl maleate and glycidyl maleate. Of these, the unsaturated dicarboxylic acids or acid anhydrides thereof are preferred, with maleic acid and nadic acid or acid anhydrides thereof being particularly preferred.

These graft monomers may be used either singly or in any combination thereof.

The modified thermoplastic norbornene polymers according to the present invention can be produced by subjecting such a graft monomer as described above and the norbornene addition polymer to graft modification by using any of various processes conventionally known. Examples of the processes include (1) a process comprising melting a norbornene addition polymer and adding a graft monomer to the melt to graft polymerize them, and (2) a process comprising dissolving a norbornene addition polymer in a solvent and then adding a graft monomer to the solution to graft copolymerize them. In addition, methods for producing the modified thermoplastic norbornene polymers include a method in which a graft monomer is mixed with an unmodified norbornene addition polymer in such a manner that the rate of graft modification of the resulting polymer reaches the desired rate, thereby modifying the polymer, and a method in which a graft-modified thermoplastic norbornene polymer having a high rate of graft modification is prepared in advance, and the modified thermoplastic norbornene polymer having the high rate of graft modification is diluted with an unmodified norbornene addition polymer to produce a graft-modified thermoplastic norbornene polymer having the desired rate of graft modification. In the present invention, any production process or method may be adopted.

In order to efficiently graft copolymerize the graft monomer, it is generally preferred to carry out a reaction in the presence of a radical initiator.

As the radical initiator, for example, organic peroxides, organic peresters, etc. may be preferably used. As specific examples of such organic peroxides, may be mentioned benzoyl peroxide, dichlorobenzoyl peroxide, dicumyl peroxide, di-tert-butyl peroxide, 2,5-dimethyl-2,5-di(peroxide benzoate)hexyne-3, 1,4-bis(tert-butyl peroxyisopropyl)benzene, lauroyl peroxide, tert-butyl peracetate, 2,5-dimethyl-2,5-di(tert-butyl peroxy)hexyne-3, 2,5-dimethyl-2,5-di(tert-butyl peroxy)hexane, tert-butyl perbenzoate, tert-butyl perphenylacetate, tert-butyl perisobutyrate, tert-butyl per-sec-octoate, tert-butyl perpivalate, cumyl perpivalate and tert-butyl perdiethylacetate. In the present invention, azo compounds may also be used as the organic peroxides. As specific examples of the azo compounds, may be mentioned azobisisobutyronitrile and dimethyl azoisobutyrate.

Of these, benzoyl peroxide, and dialkyl peroxides such as dicumyl peroxide, di-tert-butyl peroxide, 2,5-dimethyl-2,5-di(tert-butyl peroxide)hexyne-3, 2,5-dimethyl-2,5-di(tert-butyl peroxy)hexane and 1,4-bis(tert-butyl peroxyisopropyl)benzene are preferably used as the organic peroxides.

These organic peroxides may be used either singly or in any combination thereof. A proportion of the organic peroxide used is generally within a range of 0.001 to 10 parts by weight, preferably 0.01 to 5 parts by weight, more preferably 0.1 to 2.5 parts by weight per 100 parts by weight of the unmodified norbornene addition polymer.

No particular limitation is imposed on the graft-modifying reaction, and the reaction may be carried out in accordance with a method known *per se* in the art. The reaction is conducted at a temperature of generally 0 to 400°C, preferably 60 to 350°C. The reaction time is generally within a range of 1 minute to 24 hours, preferably 30 minutes to 10 hours. After completion of the reaction, a poor solvent such as methanol is added in a great amount to the reaction system to deposit a polymer formed, and the polymer is collected by filtration, washed and then dried under reduced pressure, whereby a graft-modified polymer can be obtained.

(3) Modified thermoplastic norbornene polymer:

The rate of graft modification (epoxy group content) of the modified thermoplastic norbornene polymer according to the present invention when graft-modified with an unsaturated epoxy compound is generally within a range of 3 to 50 mol%, preferably 5 to 40 mol%, more preferably 10 to 35 mol% based on the total number of monomer units in the polymer. If the epoxy group content is extremely low, the adhesion property to other materials such as metals and silicon wafers of the modified polymer becomes deteriorated. If the epoxy group content is extremely high to the contrary, the electrical properties such as dielectric constant, moisture resistance and the like of the modified polymer are deteriorated. Therefore, both modified polymers having such an extremely low epoxy group content and an extremely high epoxy group content are not preferred.

The rate of graft modification (carboxyl group content) of the modified thermoplastic norbornene polymer according to the present invention when graft-modified with an unsaturated carboxylic compound is generally within a range of 7 to 50 mol%, preferably 8 to 40 mol%, more preferably 10 to 35 mol% based on the total number of monomer units in the polymer. If the content of the carboxyl group (including acid anhydride group) is extremely low, the adhesion property to other materials such as metals and silicon wafers of the modified polymer becomes deteriorated. If the carboxyl group content is extremely high to the contrary, the electrical properties such as dielectric constant, moisture resistance and the like of the modified polymer are deteriorated. Therefore, both modified polymers having such an extremely low carboxyl group content and an extremely high carboxyl group content are not preferred.

The rate of graft modification is represented by the following equation (1):

$$\text{Rate of graft modification (mol\%)} = (X/Y) \times 100 \qquad (1)$$

wherein

X: the total number of moles of the modifying group introduced into the polymer by grafting of the unsaturated compound; and

Y: the total number of monomer units in the polymer (weight average molecular weight of the polymer/average molecular weight of the monomer).

X can be said to be the total number of moles of modifying residue introduced by the graft monomer and can be determined by $^1$H-NMR. Y is equal to a ratio of the weight average molecular weight (Mw) of the polymer/the molecular weight of the monomer. In the case of copolymerization, the molecular weight of the monomer is defined as an average molecular weight of monomers.

The molecular weights of the modified thermoplastic norbornene polymers according to the present invention are within a range of 500 to 500,000, preferably 1,000 to 200,000, more preferably 5,000 to 100,000 when expressed by a number average molecular weight (Mn) in terms of polystyrene as measured by gel permeation chromatography (GPC) using toluene as a solvent or when expressed by a number average molecular weight (Mn) in terms of polyisoprene as measured by GPC using cyclohexane as a solvent if the epoxy group-containing norbornene polymer is insoluble in toluene. If the number average molecular weight (Mn) of the modified polymer is extremely low, the heat resistance and moisture resistance of the polymer become deteriorated. If the molecular weight is extremely high on the other hand, the solubility in alkali of the polymer upon formation of via diameters is lowered. Therefore, both modified polymers having such an extremely low molecular weight and an extremely high molecular weight are not preferred.

No particular limitation is imposed on the molecular weight distribution of the modified thermoplastic norbornene polymers. However, it is preferred that their ratios (Mw/Mn) of the weight average molecular weight (Mw) to the number average molecular weight (Mn) in terms of polystyrene as measured by GPC using toluene as a solvent be generally 4.0 or lower, preferably 3.0 or lower, more preferably 2.5 or lower, since the mechanical strength of the modified polymer is highly enhanced.

The glass transition temperature (Tg) of the epoxy group-containing norbornene polymers according to the present invention may be suitably selected as necessary for the end application intended. However, it is generally 50 to 400°C. The glass transition temperature of the modified polymers obtained by using an addition polymer composed of only a norbornene monomer is preferably 200 to 350°C, more preferably 230 to 320°C. The glass transition temperature of the modified polymers obtained by using an addition copolymer composed of a norbornene monomer and a vinyl compound is preferably 80 to 170°C, more preferably 100 to 160°C.

<u>Crosslinking polymer composition</u>:

The crosslinking polymer compositions according to the present invention comprise any of the above-described modified thermoplastic norbornene polymers and a crosslinking agent as essential components.

No particular limitation is imposed on the method for crosslinking the crosslinking polymer compositions according to the present invention. For example, the crosslinking can be conducted by using heat, light, radiation and/or the like. The kind of the crosslinking agent is suitably selected according to such means. When the epoxy group-containing norbornene polymer according to the present invention is used, the ability to uniformly disperse various crosslinking agents therein also becomes good.

Into the crosslinking polymer compositions according to the present invention, as needed, a crosslinking aid, a flame retardant, other compounding additives, a solvent, etc. may be blended in addition to the crosslinking agent.

(1) Crosslinking agent:

In order to crosslink the modified thermoplastic norbornene polymers according to the present invention, for example, a method of crosslinking such a polymer by irradiation of radiation is also included. However, a method of crosslinking the polymer by blending a crosslinking agent is generally adopted. No particular limitation is imposed on the crosslinking agent. However, ① an organic peroxide, ② a crosslinking agent capable of exhibiting its effect by heat, ③ a crosslinking agent capable of exhibiting its effect by light, or the like is used.

① Organic peroxide:

Examples of the organic peroxide include ketone peroxides such as methyl ethyl ketone peroxide and cyclohexanone peroxide; peroxyketals such as 1,1-bis(t-butyl peroxy)-3,3,5-trimethylcyclohexane and 2,2-bis(t-butyl peroxy)butane; hydroperoxides such as t-butyl hydroperoxide and 2,5-dimethylhexane-2,5-dihydroperoxide; dialkyl peroxides such as dicumyl peroxide, 2,5-dimethyl-2,5-di(t-butyl peroxy)hexyne-3 and $\alpha,\alpha'$-bis(t-butyl peroxy-m-isopropyl)benzene; diacyl peroxides such as octanoyl peroxide and isobutyryl peroxide; and peroxyesters such as peroxydicarbonate. Of these, the dialkyl peroxides are preferred from the viewpoint of performance of the crosslinked

resin. It is preferred to change the kind of the alkyl group according to the forming or molding temperature.

The organic peroxides may be used either singly or in any combination thereof. The amount of the organic peroxide blended is generally 0.001 to 30 parts by weight, preferably 0.01 to 25 parts by weight, more preferably 1 to 20 parts by weight per 100 parts by weight of the modified thermoplastic norbornene polymer. The blending amount within this range is preferred because crosslinkability of the resulting composition, and properties of the crosslinked resin, such as electrical properties, chemical resistance and water resistance, are balanced with one another at a high level.

② Crosslinking agent capable of exhibiting its effect by heat:

No particular limitation is imposed on the crosslinking agent capable of exhibiting its effect by heat so far as it can cause a crosslinking reaction by heating. Examples thereof include aliphatic polyamines such as diamines, triamines and still higher polyamines, alicyclic polyamines, aromatic polyamines, bisazides, acid anhydrides, dicarboxylic acids, polyhydric phenols and polyamides. Specific examples thereof include aliphatic polyamines such as hexamethylenediamine, triethylenetetramine, diethylenetriamine and tetraethylenepentamine; alicyclic polyamines such as diaminocyclohexane, 3(4),8(9)-bis(aminomethyl)tricyclo[5,2,1,$0^{2,6}$]decane, 1,3-(diaminomethyl)cyclohexane, menthenediamine, isophoronediamine, N-aminoethylpiperazine, bis(4-amino-3-methylcyclohexyl)methane and bis(4-aminocyclohexyl)methane; aromatic polyamines such as 4,4'-diaminodiphenyl ether, 4,4'-diaminodiphenylmethane, α,α'-bis(4-aminophenyl)-1,3-diisopropylbenzene, α,α'-bis(4-aminophenyl)-1,4-diisopropylbeniene, 4,4'-diaminodiphenyl sulfone and m-phenylenediamine; bisazides such as 4,4'-bisazidobenzal(4-methyl)cyclohexanone, 4,4'-diazidochalcone, 2,6-bis(4'-azidobenzal)cyclohexanone, 2,6-bis(4'-azidobenzal)-4-methylcyclohexanone, 4,4'-diazidodiphenyl sulfone, 4,4'-diazidodiphenylmethane and 2,2'-diazidostilbene; acid anhydrides such as phthalic anhydride, pyromellitic anhydride, benzophenonetetracarboxylic acid anhydride, nadic anhydride, 1,2-cyclohexanedicarboxylic acid and maleic anhydride-modified polypropylene; dicarboxylic acids such as fumaric acid, phthalic acid, maleic acid, trimellitic acid and himic acid; polyhydric phenols such as phenol novolak resins and cresol novolak resin; polyhydric alcohols such as tricyclodecanediol, diphenylsilanediol, ethylene glycol and derivatives thereof, diethylene glycol and derivatives thereof, and triethylene glycol and derivatives thereof; and polyamides such as nylon 6, nylon 66, nylon 610, nylon 11, nylon 612, nylon 12, nylon 46, methoxymethylated polyamide, polyhexamethylenediamine terephthalamide and polyhexamethylene isophthalamide.

These crosslinking agents may be used either singly or in any combination thereof. Of these, the aromatic polyamines, acid anhydrides, polyhydric phenols and polyhydric alcohols are preferred for reasons of providing a crosslinked resin excellent in heat resistance, mechanical strength, adhesion property and dielectric properties (low dielectric constant and dielectric loss tangent). Among others, 4,4-diaminodiphenylmethane (aromatic polyamine) and polyhydric phenols are particularly preferred.

No particular limitation is imposed on the amount of the crosslinking agent blended. From the viewpoints of being able to efficiently conduct a crosslinking reaction and improve the physical properties of the resulting crosslinked resin, and being profitable, however, it is generally within a range of 0.001 to 30 parts by weight, preferably 0.01 to 25 parts by weight, more preferably 1 to 20 parts by weight per 100 parts by weight of the modified thermoplastic norbornene polymer. If the amount of the crosslinking agent is too little, the resulting composition becomes hard to undergo crosslinking, and so sufficient heat resistance and solvent resistance cannot be imparted to the composition. To the contrary, any amount too great results in a crosslinked resin lowered in properties such as water-absorption property and dielectric properties. It is hence not preferable to use the crosslinking agent in any amount outside the above range. Therefore, the blending amount within this range is preferred because these properties are balanced with one another at a high level.

As needed, a crosslinking accelerator (hardening accelerator) may also be blended to enhance the efficiency of the crosslinking reaction.

As examples of the hardening accelerator, may be mentioned amines such as pyridine, benzyldimethylamine, triethanolamine, triethylamine and imidazoles. The hardening accelerator is added in order to regulate the rate of the crosslinking reaction and further enhance the efficiency of the crosslinking reaction. No particular limitation is imposed on the amount of the hardening accelerator blended. However, it is used within a range of generally 0.1 to 30 parts by weight, preferably 1 to 20 parts by weight per 100 parts by weight of the thermoplastic norbornene polymer. The blending amount of the hardening accelerator within this range is preferred because crosslinking density, dielectric properties, water absorption and the like of the crosslinked resin are balanced with one another at a high level. Among others, imidazoles are preferred in that a crosslinked resin excellent in dielectric properties can be provided.

③ Crosslinking agent capable of exhibiting its effect by light:

No particular limitation is imposed on the crosslinking agent (hardener) capable of exhibiting its effect by light

so far as it is a photoreactive substance which reacts with the modified thermoplastic norbornene polymer by irradiation of actinic rays such as ultraviolet rays such as g rays, h rays or i rays, far ultraviolet rays, X rays, or electron rays to form a crosslinked compound. Examples thereof include aromatic bisazide compounds, photo-induced amine generators and photo-induced acid generators.

Specific typical examples of the aromatic bisazide compounds include 4,4'-diazidochalcone, 2,6-bis(4'-azidobenzal)cyclohexanone, 2,6-bis(4'-azidobenzal)-4-methylcyclohexanone, 4,4'-diazidodiphenyl sulfone. 4,4'-diazidobenzophenone, 4,4'-diazidophenyl, 2,7-diazidofluorene and 4,4'-diazidophenylmethane. These compounds may be used either singly or in any combination thereof.

Specific examples of the photo-induced amine generators include o-nitrobenzyloxycarbonylcarbamates. 2,6-dinitrobenzyloxycarbonylcarbamates and $\alpha,\alpha$-dimethyl-3,5-dimethoxybenzyloxycarbonylcarbamates of aromatic amines or aliphatic amines. More specifically, there may be mentioned o-nitrobenzyloxycarbonylcarbamates of aniline, cyclohexylamine, piperidine, hexamethylenediamine, triethylenetetramine, 1,3-(diaminomethyl)cyclohexane, 4,4'-diaminodiphenyl ether, 4,4'-diaminodiphenylmethane, phenylenediamine and the like. These compounds may be used either singly or in any combination thereof.

The photo-induced acid generator is a substance which forms a Brønsted acid or Lewis acid upon exposure to actinic rays. Examples thereof include onium salts, halogenated organic compounds, quinonediazide compounds, $\alpha,\alpha$-bis(sulfonyl)diazomethane compounds, $\alpha$-carbonyl-$\alpha$-sulfonyl-diazomethane compounds, sulfone compounds, organic acid ester compounds, organic acid amide compounds and organic acid imide compounds. These compounds, which cleave upon exposure to the actinic rays to form an acid, may be used either singly or in any combination thereof.

As examples of other photo-crosslinking agents, may be mentioned benzoin alkyl ether compounds such as benzoin ethyl ether and benzoin isobutyl ether; benzophenone compounds such as benzophenone, methyl-o-benzoyl benzoate and 4,4,-dichlorobenzophenone; benzyl compounds such as dibenzyl and benzyl methyl ketal; acetophenone compounds such as 2,2-diethoxyacetophenone, 2-hydroxy-2-methylpropiophenone, 4-isopropyl-2-hydroxy-2-methylpropiophenone, 1,1-dichloroacetophenone, 2,2-diethoxyacetophenone and 4'-phenoxy-2,2-dichloroacetophenone; thioxanthone compounds such as 2-chlorothioxanthone, 2-methylthioxanthone and 2-isopropylthioxanthone; anthraquinone compounds such as 2-ethylanthraquinone, 2-chloroanthraquinone and naphthoquinone; propiophenone compounds such as 2-hydroxy-2-methylpropiophenone and 4'-dodecyl-2-hydroxy-2-methylpropiophenone; and organic acid metal salts such as cobalt octenate, cobalt naphthenate, manganese octenate and manganese naphthenate.

No particular limitation is imposed on the amount of these photoreactive compounds blended. From the viewpoints of being able to efficiently conduct the reaction with the modified thermoplastic norbornene polymer, not impairing the physical properties of the resulting crosslinked resin, and being profitable, however, it is generally within a range of 0.001 to 30 parts by weight, preferably 0.01 to 25 parts by weight, more preferably 1 to 20 parts by weight per 100 parts by weight of the modified thermoplastic norbornene polymer. If the amount of the photoreactive substance added is too little, the resulting composition becomes hard to undergo crosslinking, and so sufficient heat resistance and solvent resistance cannot be imparted to the composition. On the other hand, any amount too great results in a crosslinked resin lowered in properties such as water-absorption property and dielectric properties. It is hence not preferable to use the photoreactive compound in any amount outside the above range. Therefore, the blending amount within this range is preferred because these properties are balanced with one another at a high level.

(2) Crosslinking aid:

In the present invention, a crosslinking aid may be used for the purpose of more enhancing the crosslinkability and the dispersibility of the compounding additives.

No particular limitation is imposed on the crosslinking aid. Publicly known compounds disclosed in Japanese Patent Application Laid-Open No. 34924/1987 and the like may be used. Examples thereof include oxime • nitroso type crosslinking aids such as quinone dioxime, benzoquinone dioxime and p-nitrosophenol; maleimide type crosslinking aids such as N,N-m-phenylenebismaleimide; allyl type crosslinking aids such as diallyl phthalate, triallyl cyanurate and triallyl isocyanurate; methacrylate type crosslinking aids such as ethylene glycol dimethacrylate and trimethylolpropane trimethacrylate; and vinyl type crosslinking aids such as vinyltoluene, ethylvinylbenzene and divinylbenzene. Of these, the allyl type crosslinking aids and methacrylate type crosslinking aids are preferred because they make it easy to uniformly disperse compounding additives.

The amount of the crosslinking aid added is suitably selected according to the kind of the crosslinking agent used. However, it is generally 0.1 to 10 parts by weight, preferably 0.2 to 5 parts by weight per part by weight of the crosslinking agent. If the amount of the crosslinking aid added is too little, the resulting composition becomes hard to undergo crosslinking. On the other hand, any amount too great results in a crosslinked resin having a possibility that its electrical properties, moisture resistance and the like may be deteriorated.

(3) Flame retardant:

The flame retardant is not an essential component. However, it is preferred that the flame retardant be added to the modified thermoplastic norbornene polymer compositions when the composition is used for electronic parts. No particular limitation is imposed on the flame retardant. However, those which undergo none of decomposition, denaturation and deterioration by the crosslinking agent (hardener) are preferred.

Various kinds of chlorine- or bromine-containing flame retardants may be used as halogen-containing flame retardants. From the viewpoints of flameproofing effect, heat resistance upon forming or molding, dispersibility in resins and influence on the physical properties of the resins, however, the following flame retardants may be preferably used. Namely, preferable examples thereof include hexabromobenzene, pentabromoethylbenzene, hexabromobiphenyl, decabromodiphenyl, hexabromodiphenyl oxide, octabromodiphenyl oxide, decabromodiphenyl oxide, pentabromocyclohexane, tetrabromobisphenol A and derivatives thereof [for example, tetrabromobisphenol A-bis(hydroxyethyl ether), tetrabromobisphenol A-bis(2,3-dibromopropyl ether), tetrabromobisphenol A-bis(bromoethyl ether), tetrabromobisphenol A-bis(allyl ether), etc.], tetrabromobisphenol S and derivative thereof [for example, tetrabromobisphenol S-bis(hydroxyethyl ether), tetrabromobisphenol S-bis(2,3-dibromopropyl ether), etc.], tetrabromophthalic anhydride and derivatives thereof [for example, tetrabromophthalimide, ethylenebistetrabromophthalimide, etc.], ethylenebis(5,6-dibromonorbornene-2,3-dicarboxyimide), tris-(2,3-dibromopropyl-1) isocyanurate, adducts of hexabromocyclopentadiene by Diels-Alder reaction, tribromophenyl glycidyl ether, tribromophenyl acrylate, ethylenebistribromophenyl ether, ethylenebispentabromophenyl ether, tetradecabromodiphenoxybenzene, brominated polystyrene, brominated polyphenylene oxide, brominated epoxy resins, brominated polycarbonate, polypentabromobenzyl acrylate, octabromonaphthalene, hexabromocyclododecane, bis(tribromophenyl)fumaramide and N-methylhexabromodiphenylamine.

These flame retardants may be used either singly or in any combination thereof. The amount of the flame retardant added is generally 3 to 150 parts by weight, preferably 10 to 140 parts by weight, particularly preferably 15 to 120 parts by weight per 100 parts by weight of the modified thermoplastic norbornene polymer.

As a flame retardant auxiliary for causing the flame retardant to more effectively exhibit its flameproofing effect, for example, an antimonial flame retardant auxiliary such as antimony trioxide, antimony pentoxide, sodium antimonate or antimony trichloride may be used. These flame retardant auxiliaries are used in a proportion of generally 1 to 30 parts by weight, preferably 2 to 20 parts by weight per 100 parts by weight of the flame retardant.

(4) Other polymer components:

In the present invention, rubbery polymers and other thermoplastic resins may be blended into the crosslinking polymer compositions as needed.

The rubbery polymers are polymers having a glass transition temperature of 40°C or lower and include general rubber-like polymers and thermoplastic elastomers. The Mooney viscosity ($ML_{1+4}$, 100°C) of such a rubbery polymer is suitably selected as necessary for the end application intended and is generally 5 to 200.

Examples of the rubber-like polymers include ethylene-$\alpha$-olefin type rubbery polymers; ethylene-$\alpha$-olefin-polyene terpolymer rubbers; copolymers of ethylene and an unsaturated carboxylic acid ester, such as ethylene-methyl methacrylate copolymers and ethylene-butyl acrylate copolymers; copolymers of ethylene and a fatty acid vinyl ester, such as ethylene-vinyl acetate copolymers; polymers of acrylic acid alkyl esters such as ethyl acrylate, butyl acrylate, hexyl acrylate, 2-ethylhexyl acrylate and lauryl acrylate; diene rubbers such as polybutadiene, polyisoprene, styrene-butadiene or styrene-isoprene random copolymers, acrylonitrile-butadiene copolymers, butadiene-isoprene copolymers, butadiene-alkyl (meth)acrylate copolymers, butadiene-alkyl (meth)acrylate-acrylonitrile terpolymers and butadiene-alkyl (meth)acrylate-acrylonitrile-styrene tetrapolymers; and butylene-isoprene copolymers

Examples of the thermoplastic elastomers include aromatic vinyl-conjugated diene block copolymers such as styrene-butadiene block polymers, hydrogenated styrene-butadiene block copolymers, styrene-isoprene block copolymers and hydrogenated styrene-isoprene block copolymers, low crystalline polybutadiene resins. ethylene-propylene elastomers, styrene-grafted ethylene-propylene elastomers, thermoplastic polyester elastomers, and ethylenic ionomer resins. Of these thermoplastic elastomers, the hydrogenated styrene-butadiene block copolymers and hydrogenated styrene-isoprene block copolymers are preferred. As specific examples thereof, may be mentioned those described in Japanese Patent Application Laid-Open Nos. 133406/1990, 305814/1990, 72512/1991 and 74409/1991, etc.

Examples of the other thermoplastic resins include low density polyethylene, high density polyethylene, linear low density polyethylene, very low density polyethylene, ethylene-ethyl acrylate copolymers, ethylene-vinyl acetate copolymers, polystyrene, poly(phenylene sulfide), poly(phenylene ether), polyamide, polyester, polycarbonate and cellulose triacetate.

These rubbery polymers and other thermoplastic resins may be used either singly or in any combination thereof. The blending amount thereof is suitably selected within limits not impeding the objects of the present invention.

(5) Other compounding additives:

To the crosslinking polymer compositions according to the present invention, may be added proper amounts of other compounding additives such as heat stabilizers, weathering stabilizers, leveling agents, antistatic agents, slip agents, antiblocking agents, anti-fogging agents, lubricants, dyes, pigments, natural oil, synthetic oil, wax and organic or inorganic fillers as needed.

Specific examples thereof include phenolic antioxidants such as tetrakis[methylene-3(3,5-di-t-butyl-4-hydroxyphenyl) propionate]methane, alkyl β-(3,5-di-t-butyl-4-hydroxyphenyl)propionates and 2,2'-oxamidobis[ethyl-3(3,5-di-t-butyl-4-hydroxyphenyl) propionate]; phosphoric stabilizers such as trisnonylphenyl phosphite, tris(2,4-di-t-butylphenyl) phosphite and tris(2,4-di-t-butylphenyl) phosphite; fatty acid metal salts such as zinc stearate, calcium stearate and calcium 12-hydroxystearate; polyhydric alcohol fatty acid esters such as glycerol monostearate, glycerol monolaurate, glycerol distearate, pentaerythritol monostearate, pentaerythritol distearate and pentaerythritol tristearate; synthetic hydrotalcite; amine type antistatic agents; leveling agents for paints, such as fluorine-containing nonionic surfactants, special acrylic resin type leveling agents and silicone type leveling agents; coupling agents such as silane coupling agents, titanate coupling agents, aluminum-containing coupling agents and zircoaluminate coupling agents; plasticizers; and colorants such as pigments and dyes.

As examples of the organic or inorganic fillers, may be mentioned silica, diatomaceous earth, alumina, titanium oxide, magnesium oxide, pumice powder, pumice balloon, basic magnesium carbonate, dolomite, calcium sulfate, potassium titanate, barium sulfate, calcium sulfite, talc, clay, mica, asbestos, glass fibers, glass flake, glass beads, calcium silicate, montmorillonite, bentonite, graphite, aluminum powder, molybdenum sulfide, boron fibers, silicon carbide fibers, polyethylene fibers, polypropylene fibers, polyester fibers and polyamide fibers.

(6) Solvent:

In the present invention, the modified norbornene polymers may be dissolved in a solvent to prepare impregnating solutions for prepregs, produce sheets by a solution casting method, or form films by a coating method.

In the case where the modified thermoplastic norbornene polymer is dissolved in a solvent, examples of the solvent used include aromatic hydrocarbons such as toluene, xylene and ethylbenzene; aliphatic hydrocarbons such as n-pentane, hexane and heptane; alicyclic hydrocarbons such as cyclohexane; and halogenated hydrocarbons such as chlorobenzene, dichlorobenzene and trichlorobenzene.

The solvent is used in an amount sufficient to uniformly dissolve or disperse the modified thermoplastic norbornene polymer and the individual components optionally blended therein. The amount is generally controlled in such a manner that a solids concentration amounts to 1 to 80 wt.%, preferably 5 to 60 wt.%, more preferably 10 to 50 wt.%.

<u>Insulating material</u>:

The epoxy group-containing norbornene polymers and crosslinking polymer compositions according to the present invention are particularly useful as insulating materials and can be used in the form of uncrosslinked moldings, photo-crosslinked moldings, etc.

[Heat-crosslinked molding]

The crosslinking polymer compositions according to the present invention can be used in the form of various kinds of moldings. The crosslinking polymer composition is molded after dissolving it in a solvent so as not to cause deterioration of moldability due to crosslinking in the course of molding, or by melting it at a temperature at which it undergoes no crosslinking, or crosslinking proceeds only at a sufficiently low rate. Specifically, the crosslinking polymer composition dissolved in a solvent is cast, and the solvent is removed to form a sheet (or a film), or a base material is impregnated with the composition dissolved in the solvent to conduct molding.

(1) Prepreg:

As a specific example of moldings of the crosslinking polymer compositions according to the present invention, may be mentioned prepregs. Each prepreg is produced by uniformly dissolving or dispersing the crosslinking polymer composition and various compounding additives in a solvent such as toluene, cyclohexane or xylene, impregnating a reinforcing base material with the solution or dispersion and then drying the base material to remove the solvent. The prepreg is preferably produced so as to give a thickness of about 50 to 500 μm.

As the solvent, may be used any of such solvents as described above. The amount of the solvent used is controlled in such a manner that the solids concentration of the solution amounts to generally 1 to 80 wt.%, preferably 5 to

60 wt.%, more preferably 10 to 50 wt.%.

Examples of usable reinforcing base materials include paper base materials (linter paper, kraft paper, etc.), glass base materials (glass cloth, glass mat, glass paper, quartz fibers, etc.) and synthetic resin fiber base materials (polyester fibers, Aramide fibers, etc.). These reinforcing base materials may be surface treated with a treating agent such as a silane coupling agent. These reinforcing base materials may be used either singly or in any combination thereof.

The amount of the modified thermoplastic norbornene polymer composition to the reinforcing base material is suitably selected as necessary for the end application intended. However, it is generally 1 to 90 wt.%, preferably 10 to 60 wt.% based on the reinforcing base material.

(2) Sheet:

As a specific example of moldings of the crosslinking polymer compositions according to the present invention, may be mentioned sheets. No particular limitation is imposed on a process for producing such a sheet. However, a casting process is generally used. For example, the crosslinking polymer composition according to the present invention is dissolved or dispersed in a solvent such as toluene, xylene or cyclohexane so as to give a solids concentration of about 5 to 50 wt.%, the solution or dispersion is cast or coated on a support having a smooth surface, the solvent is removed by drying or the like, and the dried product is separated from the support to obtain a sheet. When the solvent is removed by drying, it is preferred to select a method by which foaming by rapid drying does not occur. For example, it is only necessary to volatilize the solvent to a certain extent at a low temperature and then raise the temperature so as to sufficiently volatilize the solvent.

As the support having the smooth surface, may be used a planished metal plate, a carrier film made of a resin, or the like. When the resin-made carrier film is used, a solvent to be used and drying conditions are determined taking the solvent resistance and heat resistance of a material of the carrier film into consideration.

Sheets obtained by the casting process generally have a thickness of about 10 μm to 1 mm. These sheets can be used as interlayer insulating films, films for forming moistureproof layers, etc. by crosslinking them. They may also be used in the production of laminates which will be described subsequently.

(3) Laminate:

As a specific example of moldings of the crosslinking polymer compositions according to the present invention, may be mentioned laminates. Specifically, such a laminate is obtained by stacking a plurality of the above-described prepregs and/or uncrosslinked sheets on one another and hot-pressing them, thereby crosslinking and mutually fusion-bonding them into a necessary thickness. When a laminated sheet is used as a circuit board, a circuit is formed by, for example, laminating an electrically conductive layer for wiring composed of a metal foil or the like, or etching the surface. The electrically conductive layer for wiring may be laminated not only on the outer surface of the laminated sheet as a finished article, but also on in the interior of the laminated sheet according to the purpose. In order to prevent warpage upon a secondary processing such as etching, it is preferred to laminate laminating materials in combination so as to vertically symmetrize. For example, the surfaces of the stacked prepregs and/or sheets are heated to a fusion-bonding temperature according to the norbornene resin used or higher generally about 150 to 300°C, and they are pressed under a pressure of about 30 to 80 kgf/cm$^2$, thereby crosslinking and mutually fusion-bonding the respective layers to obtain a laminated sheet.

Other methods for applying a metal to these insulating layers or a base material include vapor deposition, electroplating, sputtering, ion plating, spraying and layering. Examples of metals commonly used include copper, nickel, tin, silver, gold, aluminum, platinum, titanium, zinc and chromium. Copper is oftenest used in circuit boards.

The moldings from the crosslinking polymer compositions according to the present invention can be provided as crosslinked moldings by heating them to a certain temperature or higher by themselves or in the form of laminates to crosslink them.

In the case where the crosslinking is conducted by heating (using a heat-crosslinking agent), the temperature is mainly determined by a combination of an organic peroxide and a crosslinking aid. However, the crosslinking is conducted by heating a molding to a temperature of generally 80 to 350°C, preferably 120 to 300°C, more preferably 150 to 250°C. Crosslinking time is preferably determined to be about 4 times as much as the half-life of the organic peroxide, and is generally 5 to 120 minutes, preferably 10 to 90 minutes, more preferably 20 to 60 minutes. Examples of the crosslinked moldings include laminated sheets, circuit boards, multilayer-interconnection laminates and films for forming moistureproof layers.

[Photo-crosslinked moldings]

Conditions in the case where crosslinking is conducted by exposure will now be shown.

As a preferable example of the crosslinked moldings, a laminate of a multilayer-interconnection structure will hereinafter be described. No particular limitation is imposed on the kind of the crosslinking agent used in this case. However, it is preferred that a photo-crosslinking agent be blended when higher-density assembly is conducted.

The laminate of the multilayer-interconnection structure is produced by applying the crosslinking polymer composition according to the present invention on to a substrate having a wiring layer (lower layer) in which a pattern has been formed, drying the composition to form a film (insulating layer), exposing the film through a prescribed photomask, dissolving the exposed film with a developer to remove a part of the film so as to form via holes and then forming an additional wiring layer (upper layer) thereon. The formation of the insulating layer and wiring layer may be repeated to form a more higher multilayer structure.

(a) As the substrate having the wiring layer in which the pattern has been formed, there may be used, for example, a substrate such as a ceramic or silicon wafer, on which a first metal wiring has been formed by cleaning the surface of the substrate by sputtering, forming a film of aluminum in a thickness of up to about 4 μm by a sputtering method, successively forming a film of chromium in a thickness of about 0.15 μm to form a passivation film, and then selectively etching chromium and aluminum.

(b) A solution of the crosslinking polymer composition according to the present invention is then applied by a spin coating or casting method on to the substrate having the patterned wiring layer and then prebaked at about 90 to 100°C for about 60 seconds to 10 minutes to form a first insulating layer.

(c) The formation of via holes in the insulating layer is conducted in the following manner. When the crosslinking polymer composition contains the crosslinking agent capable of exhibiting its effect by heat, the insulating layer is completely cured at 250°C or higher for 3 hours in a nitrogen atmosphere, and via holes 10 to 50 μm in diameter are then formed by an excimer laser or the like. When the crosslinking polymer composition contains the photo-crosslinking agent, the insulating layer is exposed to ultraviolet rays under conditions of 1 to 50 $mJ/cm^2$ using a photomask, developed with an organic solvent such as toluene to form via holes 10 to 50 μm in diameter, and then cured by heating it at 250°C or higher for 3 hours in a nitrogen atmosphere.

(d) The formation of the wiring layer as the upper layer is conducted in the following manner. A second metal layer is formed on the insulating layer, in which the via holes have been formed, in the same manner as in the step (a) to form the second metal wiring layer having a conductor width and conductor spacing of 20 to 50 μm, respectively.

An interlayer insulating layer comprising 3 to several insulating films can be formed by repeating the processes (b) to (d). These laminates of the multilayer-interconnection structure are useful as multi-chip modules (MCMs), build-up substrates and the like.

(4) Crosslinked molding:

Examples of crosslinked moldings according to the present invention include laminated sheets, circuit boards, interlayer insulating films and films for forming moistureproof layers. The crosslinked moldings according to the present invention generally have a water absorption of at most 0.03%, and a dielectric constant of 2.0 to 4.0 and a dielectric loss tangent of 0.0005 to 0.005 as measured at a frequency of 1 MHz. Therefore, the moldings according to the present invention are superior in moisture resistance and electrical properties to the conventional thermosetting resin moldings. The heat resistance of the crosslinked moldings according to the present invention is equal to that of the conventional thermosetting resin moldings. Accordingly, even when a laminated sheet on which a copper foil has been laminated is brought into contact with a solder of 260°C for 30 seconds or with a solder of 300°C for 1 minute, abnormality such as delamination of the metal layer such as the copper foil and/or occurrence of blister is not observed. In addition, the crosslinked moldings according to the present invention are excellent in adhesion property to the copper foil as demonstrated by a peel strength of generally 1.4 to 2.2 $kg/cm^2$. This is far improved compared with the conventional thermoplastic norbornene resins. From these results, the laminated sheets which are crosslinked moldings according to the present invention are suitable for use as circuit boards.

Moldings obtained by using the crosslinking polymer compositions according to the present invention as thermoplastic resins are useful as electronic parts such as connectors, relays and capacitors; electronic parts such as injection-molded sealing parts for semiconductor devices such as transistors, ICs and LSIs; and body tubes for optical lenses and parts such as polygon mirrors and Fθ mirrors.

When the crosslinking polymer compositions according to the present invention are used in a state dissolved in an organic solvent, they are useful for uses such as sealing materials for potting and cast molding.

When the crosslinking polymer compositions according to the present invention are used as transfer molding

materials, they are useful as packaging (sealing) materials for semiconductor devices.

The crosslinking polymer compositions according to the present invention can be used in the form of a film. In the case where they are used as films, there are cases ① where the crosslinking polymer composition is dissolved in an organic solvent, and the solution is formed into a film by a casting process or the like in advance to use it, and ② where the solution is applied, and the solvent is then removed to use a film formed as an overcoat. More specifically, such films are useful as, for example, insulating sheets for laminated sheets, interlayer insulating films, liquid sealing materials for semiconductor devices, overcoating materials, etc.

〈EXAMPLES〉

The present invention will hereinafter be described specifically by the following Examples and Comparative Examples. Incidentally, physical properties were measured in accordance with the following methods:

(1) The glass transition temperature was measured in accordance with the differential scanning calorimetry (DSC method).
(2) The molecular weight was determined in terms of polystyrene as measured by gel permeation chromatography (GPC) using toluene as a solvent unless expressly noted.
(3) The rates of hydrogenation in the main chain and side chain were determined by $^1$H-NMR.
(4) The total number of moles of modifying residue introduced by an unsaturated epoxy compound or unsaturated carboxylic compound was determined by $^1$H-NMR, and the rate of graft modification was calculated out in accordance with the above-described equation.
(5) The flame retardancy was determined in accordance with the US UL-94 test standard.
(6) The dielectric constant and dielectric loss tangent were determined at 1 MHz in accordance with JIS K 6911.
(7) The copper foil peeling strength was determined in the following manner. Namely, a specimen 20 mm wide and 100 mm long was cut out of a resin laminate sample, parallel notches were cut at an interval of 10 mm in the copper foil surface of the specimen, and the copper foil was continuously peeled off at a rate of 50 mm/min in a direction perpendicular to the surface by a tensile tester. The copper foil peeling strength was expressed in terms of the minimum stress value at this time.
(8) The adhesion property was evaluated by conducting a cross-cut peel strength test in accordance with JIS K 5400.
(9) The durability was determined by leaving a test sample to stand for 1,000 hours under conditions of 90°C and 95% relative humidity to observe whether visual abnormality such as blister, the corrosion and/or tarnishing of copper, and the like occurred or not.
(10) The heat resistance was determined in the following manner. After a test sample was brought into contact with a solder of 300°C for 1 minute, the appearance of the sample was observed to evaluate it in accordance with the following standard:

Good: Neither delamination nor blister was observed;
Poor: Delamination or blister was observed.

[Example 1]

A 1-liter polymerizer purged with nitrogen was charged with a cyclohexane solution of tetracyclo[4.4.0.$1^{2,5}$.$1^{7,10}$]-3-dodecene (hereinafter referred to as "TCD"), and a cyclohexane solution of $VO(OC_2H_5)Cl_2$ and a cyclohexane solution of ethylaluminum sesquichloride $[Al(C_2H_5)_{1.5}Cl_{1.5}]$ as catalysts in such a manner that their concentrations within the polymerizer amounted to 60 g/liter, 0.5 mmol/liter and 4.0 mmol/liter, respectively. To the mixture, ethylene and hydrogen were fed at rates of 15 liters/hr and 1.5 liters/hr, respectively, and the temperature within the system was controlled to 10°C. On the other hand, the polymerization reaction mixture was continuously taken out of the upper part of the polymerizer in such a manner that the total amount of the polymerization reaction mixture within a flask amounted to 1 liter, and average residence time was 0.5 hours.

A small amount of isopropyl alcohol was added to the polymerization reaction mixture taken out to terminate the polymerization. Thereafter, an aqueous solution containing concentrated hydrochloric acid in a proportion of 5 ml per liter of water was brought into contact with the polymerization reaction mixture at a ratio of 1:1 under vigorous stirring by means of a homogenizer, thereby transferring the remaining catalysts to an aqueous phase. After the mixed solution was left to rest to remove the aqueous phase, the residue was further washed twice with distilled water, thereby purifying and isolating the polymerization reaction mixture.

This polymerization reaction mixture was poured into 3 liters of acetone to deposit a resin formed. The resin was collected by filtration and then dried for 48 hours at 100°C under 1 Torr or lower.

Fifty parts by weight of the thus-obtained polymer were mixed with 100 parts by weight of allyl glycidyl ether. 10 parts by weight of dicumyl peroxide and 120 parts by weight of tert-butylbenzene to conduct a reaction at 150°C for 3 hours in an autoclave. The reaction mixture was then solidified and dried in the same manner as described above to obtain epoxy-modified Polymer (A). The result of the synthesis is shown in Table 1.

[Example 2]

Epoxy-modified Polymer (B) was obtained in the same manner as in Example 1 except that the feed rate of hydrogen was changed from 1.5 liters/hr to 2.5 liters/hr. The result of the synthesis is shown in Table 1.

[Example 3]

Maleic anhydride-modified Polymer (C) was obtained in the same manner as in Example 1 except that allyl glycidyl ether was changed to maleic anhydride. The result of the synthesis is shown in Table 1.

[Example 4]

Maleic anhydride-modified Polymer (D) was obtained in the same manner as in Example 1 except that the feed rate of hydrogen was changed from 1.5 liters/hr to 2.5 liters/hr, and allyl glycidyl ether was changed to maleic anhydride. The result of the synthesis is shown in Table 1.

[Comparative Example 1]

An unmodified hydrogenated product was synthesized in the same manner as in Example 1. The thus-obtained product is referred to as Polymer (E). The result of the synthesis is shown in Table 1.

[Comparative Example 2]

Epoxy-modified Polymer (F) was obtained in the same manner as in Example 1 except that the amounts of allyl glycidyl ether and dicumyl peroxide were changed from 100 parts by weight to 15 parts by weight and from 10 parts by weight to 1.0 part by weight, respectively. The result of the synthesis is shown in Table 1.

[Comparative Example 3]

Maleic anhydride-modified Polymer (G) was obtained in the same manner as in Example 1 except that 100 parts by weight of allyl glycidyl ether were changed to 15 parts by weight maleic anhydride, and the amount of dicumyl peroxide was changed from 10 parts by weight to 1.0 part by weight. The result of the synthesis is shown in Table 1.

[Comparative Example 4]

Unmodified Polymer (H) was obtained in the same manner as in Example 1 except that the feed rate of hydrogen was changed from 1.5 liters/hr to 0.5 liters/hr. The result of the synthesis is shown in Table 1.

Table 1

| | Polymer composition (mol%) | Polymerization method | Tg (°C) | Molecular weight | | Modifying group | Modification rate (%) | Tg (°C) | Molecular weight after modification | | Code No. |
|---|---|---|---|---|---|---|---|---|---|---|---|
| | | | | Mn x $10^4$ | Mw x $10^4$ | | | | Mn x $10^4$ | Mw x $10^4$ | |
| Ex. 1 | TCD/ethylene (38/62) | Addition | 135 | 1.52 | 3.56 | Epoxy | 18 | 159 | 1.22 | 2.67 | A |
| Ex. 2 | TCD/ethylene (38/62) | Addition | 127 | 0.77 | 1.46 | Epoxy | 23 | 160 | 0.67 | 1.28 | B |
| Ex. 3 | TCD/ethylene (38/62) | Addition | 135 | 1.52 | 3.56 | Maleic | 19 | 155 | 1.05 | 3.32 | C |
| Ex. 4 | TCD/ethylene (38/62) | Addition | 127 | 0.77 | 1.46 | Maleic | 22 | 154 | 1.13 | 3.53 | D |
| Comp. Ex. 1 | TCD/ethylene (38/62) | Addition | 135 | 1.52 | 3.56 | - | - | - | - | - | E |
| Comp. Ex. 2 | TCD/ethylene (38/62) | Addition | 135 | 1.52 | 3.56 | Epoxy | 2 | 141 | 1.49 | 3.33 | F |
| Comp. Ex. 3 | TCD/ethylene (38/62) | Addition | 135 | 1.52 | 3.56 | Maleic | 5 | 139 | 1.41 | 3.46 | G |
| Comp. Ex. 4 | TCD/ethylene (37/63) | Addition | 140 | 4.71 | 8.33 | - | - | - | - | - | H |

[Examples 5 to 8]

The respective modified polymers obtained in Examples 1 to 4 and various kinds of components were blended so as to give their corresponding compositions shown in Table 2, and the thus-obtained compositions were separately dissolved in toluene to give a solids concentration of 50 to 60 wt.%, thereby preparing respective varnishes. After these solutions were left at rest for 30 minutes, uniformity of the solutions was visually evaluated to rank them in accordance with the following standard:

Uniformity of solution:

○: The solution was completely uniform; and
X: The solution underwent phase separation.

An E glass cloth 10 cm wide, 10 cm long and about 0.5 mm thick was dipped for 10 seconds in each of these solutions, slowly pulled up and then left to stand for 1 minute. Only solids in the resin-impregnated glass cloth thus obtained were dissolved again in toluene, and the resultant solution was poured into a large amount of isopropyl acetate to solidify a modified polymer portion. The solidified polymer was collected by filtration. On the other hand, the filtrate was poured into a large amount of methanol to collect a flame retardant portion in the same manner as described above.

These portions were separately dried for 48 hours at 70°C under 1 Torr to measure their weights. The uniformity of impregnation was evaluated on the basis of a difference between a weight ratio of the two components at this time and a weight ratio of the two components in a state of the varnish to rank it in the following standard:

Uniformity of impregnation:

◎: The difference in weight ratio was lower than 2%;
○: The difference in weight ratio was not lower than 2%, but lower than 5%;
△: The difference in weight ratio was not lower than 5%, but lower than 10%; and
X: The difference in weight ratio was not lower than 10%.

Further, an E glass cloth was dipped in and impregnated with each of the above solutions and then dried in an air oven to prepare a curable composite material (prepreg). The weight of the base material in the prepreg was controlled to 40% based on the weight of the prepreg. As needed, plural sheets of the thus-produced prepreg were stacked on one another so as to give a thickness of 0.8 mm after molding, and a copper foil 35 μm thick was placed on both sides thereof. The thus-obtained laminate was molded and cured by a hot pressing machine to obtain a resin laminate.

Various physical properties of the resin laminates obtained in such a manner were measured. As a result, all the resin laminates exhibited good dielectric constant and copper foil peeling strength and had flame retardancy of V-0.

[Comparative Examples 5 to 8]

Respective experiments were conducted in the same manner as in Examples 5 to 8 except that the modified or unmodified polymers obtained in Comparative Examples 1 to 4 were used in peace of the modified polymers obtained in Examples 1 to 4. The results are shown in Table 2.

Table 2

| | Polymer (part) | Peroxide (part) | Cross-linking aid (part) | Flame retardant (part) | Hardener (part) | Solids conc'n (%) | Uniformity | | Dielec. const. ε | Copper foil peeling strength ($kg/cm^2$) |
|---|---|---|---|---|---|---|---|---|---|---|
| | | | | | | | Solution | Impregnation | | |
| Ex. 5 | A (60) | a (1) | TAIC (5) | b (40) | Imidazole (1) | 50 | ○ | ◎ | 3.00 | 1.8 |
| Ex. 6 | B (60) | a (1) | TAIC (5) | b (40) | Imidazole (1) | 60 | ○ | ◎ | 3.05 | 2.2 |
| Ex. 7 | C (60) | a (1) | TAIC (5) | b (40) | Imidazole (1) | 50 | ○ | ◎ | 3.15 | 2.2 |
| Ex. 8 | D (60) | a (1) | TAIC (5) | b (40) | Imidazole (1) | 60 | ○ | ◎ | 3.05 | 2.2 |
| Comp. Ex. 5 | E (60) | a (1) | TAIC (5) | b (40) | Imidazole (1) | 50 | ○ | ◎ | 2.90 | 0.6 |
| Comp. Ex. 6 | F (60) | a (1) | TAIC (5) | b (40) | Imidazole (1) | 60 | ○ | ◎ | 2.92 | 1.0 |
| Comp. Ex. 7 | G' (60) | a (1) | TAIC (5) | b (40) | Imidazole (1) | 50 | ○ | ◎ | 2.95 | 1.0 |
| Comp. Ex. 8 | H (60) | a (1) | TAIC (5) | b (40) | Imidazole (1) | 30 | × | × | - | - |

(Note)

Peroxide: a = 2,5-Dimethyl-2,5-di(t-butyl peroxy)hexyne-3;

Crosslinking aid: TAIC = Triallyl isocyanurate;

Flame retardant: b = Brominated bisphenol A type epoxy resin (AER 8010, product of Asahi-CIBA Limited; Br content: 5 wt.%);

Hardener: Imidazole = 2-Ethyl-4-methylimidazole.

It is understood from Table 2 that even when the modified polymers (Examples 5 to 8) according to the present invention are prepared into solutions at a solids concentration of 50 to 60 wt.%, the compounding additives such as the crosslinking agent, crosslinking aid, flame retardant and hardener can be uniformly dispersed therein, and the resultant moldings are excellent in both dielectric constant and copper foil peeling strength. On the other hand, it is understood that the unmodified polymers and the modified polymer low in modification rate have insufficient copper foil peeling strength. When the unmodified Polymer (H) having a high molecular weight was used, the compounding additives were unable to be uniformly dispersed therein, and its ability to impregnate the glass cloth was also poor.

[Example 9]

A glass container having an internal volume of 300 ml purged with nitrogen was charged with 500 mg of dichlorobis(benzonitrile)palladium and 75 ml of 2-norbornene (hereinafter abbreviated as "NB") to conduct a polymerization reaction at 90°C for 4 hours. After completion of the reaction, the reaction mixture was poured into a large amount of methanol to deposit a polymer formed. The polymer was collected by filtration, washed and then dried under reduced pressure, thereby obtaining 42 g of a polymer (Mn = 5,600, Tg = 267°C).

Dissolved in 120 parts by weight of cyclohexane were 50 parts by weight of the thus-obtained polymer, 15 parts by weight of 5,6-epoxy-1-hexene and 3 parts by weight of dicumyl peroxide, and a reaction was conducted at 150°C for 5 hours in an autoclave. The resultant reaction mixture was poured into 240 parts by weight of isopropyl alcohol to solidify a reaction product. The reaction product thus solidified was then dried under reduced pressure at 100°C for 20 hours to obtain 50 parts by weight of epoxy-modified norbornene Polymer (I).

This modified Polymer I had Mn of 6,100 and Tg of 267°C. The epoxy group content (modification rate) in the modified Polymer I was 5.5% per repeating structural unit of the polymer as measured by $^1$H-NMR. The result of the synthesis is shown in Table 3.

[Example 10]

A glass container having an internal volume of 300 ml purged with nitrogen was charged with 75 ml of toluene, 2 mmol of methylaluminoxane and 0.1 mmol of palladium chloride, and then with 30 ml of tetracyclododecene (hereinafter abbreviated as "TCD") to conduct a polymerization reaction at 80°C for 4 hours. After completion of the reaction, the reaction mixture was poured into a large amount of methanol to deposit a polymer formed. The polymer was collected by filtration, washed and then dried under reduced pressure, thereby obtaining 8.5 g of a polymer (Mn = 21,000, Tg = 340°C).

Dissolved in 120 parts by weight of cyclohexane were 50 parts by weight of the thus-obtained polymer, 15 parts by weight of 5,6-epoxy-1-hexene and 3 parts by weight of dicumyl peroxide, and a reaction was conducted at 150°C for 6 hours in an autoclave. The resultant solution of a reaction product was poured into 240 parts by weight of isopropyl alcohol to solidify the reaction product. The reaction product thus solidified was then dried under reduced pressure at 100°C for 20 hours to obtain 50 parts by weight of epoxy-modified norbornene Polymer (J). This modified Polymer J had Mn of 21,900 and Tg of 342°C. The epoxy group content (modification rate) in the modified Polymer J was 12.8% per repeating structural unit of the polymer as measured by $^1$H-NMR. The result of the synthesis is shown in Table 3.

[Example 11]

An addition copolymer of 2-norbornene (NB) and 5-decyl-2-norbornene (hereinafter abbreviated as "DNB") [number average molecular weight (Mn) = 69,200, weight average molecular weight (Mw) = 132,100, both, in terms of polystyrene; compositional ratio (NB/DNB) of monomers = 76/24 (molar ratio); Tg = 260°C] was obtained in accordance with the publicly known process described in U.S. Patent No. 5,468,819.

Dissolved in 100 parts by weight of t-butylbenzene were 50 parts by weight of the thus-obtained polymer, 10 parts by weight of 5,6-epoxy-1-hexene and 1.0 part by weight of dicumyl peroxide, and a reaction was conducted at 140°C for 6 hours. The resultant solution of a reaction product was poured into 300 parts by weight of methanol to solidify the reaction product. The reaction product thus solidified was dried under reduced pressure at 100°C for 20 hours to obtain epoxy-modified norbornene Polymer (K). The result of the synthesis is shown in Table 3.

[Example 12]

Maleic anhydride-modified Polymer (L) was obtained in the same manner as in Example 9 except that 15 parts by weight of 5,6-epoxy-1-hexene were changed to 15 parts by weight of maleic anhydride. The result of the synthesis is shown in Table 3.

[Example 13]

An addition terpolymer of 2-norbornene (NB), 5-hexyl-2-norbornene (hereinafter abbreviated as "HNB") and 5-ethylidene-2-norbornene (hereinafter abbreviated as "ENB") [number average molecular weight (Mn) = 71,000, weight average molecular weight (Mw) = 107,000, both, in terms of polystyrene; compositional ratio (NB/HNB/ENB) of monomers = 74/23/3 (molar ratio); Tg = 323°C] was obtained in accordance with the same process as in Example 11.

Dissolved in 100 parts by weight of t-butylbenzene were 50 parts by weight of the thus-obtained polymer, 15 parts by weight of 5,6-epoxy-1-hexene and 1.0 part by weight of dicumyl peroxide, and a reaction was conducted at 140°C for 6 hours. The resultant solution of a reaction product was poured into 300 parts by weight of methanol to solidify the reaction product. The reaction product thus solidified was dried under reduced pressure at 100°C for 20 hours to obtain epoxy-modified norbornene Polymer (M). The result of the synthesis is shown in Table 3.

[Comparative Example 9]

After an autoclave having an internal volume of 1 liter purged with nitrogen was charged with 360 ml of toluene, 100 g of NB and 3.6 mmol of methylaluminoxane, 1 $kg/cm^3$ of ethylene gas was charged therein. A toluene solution containing 0.1 mmol of dimethylsilylenebis(t-butylamido)titanium dichloride was added to the contents to initiate polymerization. After the reaction was conducted at 20°C for 1 hour while keeping the ethylene pressure at 1 $kg/cm^3$, the reaction mixture was poured into a large amount of methanol to deposit a polymer formed. The polymer was collected by filtration, washed and then dried under reduced pressure, thereby obtaining 35 g of a polymer (NB content = 56 mol%, Mn = 48,200, Tg = 148°C). This polymer is referred to as Polymer (O). The result of the synthesis is shown in Table 3.

[Comparative Example 10]

After an autoclave having an internal volume of 1 liter purged with nitrogen was charged with 400 ml of toluene, and successively with 100 g of TCD and 4.0 mmol of methylaluminoxane, ethylene gas was charged therein to keep an ethylene pressure at 2 $kg/cm^3$. A toluene solution containing 0.040 mmol of isopropylene-(1-indenylcyclopentadienyl)zirconium dichloride was added to the contents to initiate polymerization. After the reaction was conducted at 70°C for 1 hour, the reaction mixture was poured into a large amount of methanol to deposit a polymer formed. The polymer was collected by filtration, washed and then dried under reduced pressure, thereby obtaining 18 g of a polymer (TCD content = 45 mol%, Mn = 46,200, Tg = 148°C).

Dissolved in 120 parts by weight of cyclohexane were 50 parts by weight of the thus-obtained polymer, 6 parts by weight of 5,6-epoxy-1-hexene and 1.5 parts by weight of dicumyl peroxide, and a reaction was conducted at 150°C for 3 hours in an autoclave. The resultant solution of a reaction product was poured into 240 parts by weight of isopropyl alcohol to solidify the reaction product. The reaction product thus solidified was then dried under reduced pressure at 100°C for 20 hours to obtain 50 parts by weight of epoxy-modified norbornene Polymer (P). This modified Polymer P had Mn of 47,100 and Tg of 148°C. The epoxy group content in this modified Polymer P was 1.2% per repeating structural unit of the polymer as measured by $^1H$-NMR. The result of the synthesis is shown in Table 3.

[Comparative Example 11]

A glass container having an internal volume of 300 ml purged with nitrogen was charged with 100 ml of toluene, 6 mmol of methylaluminoxane and 0.3 mmol of palladium chloride. Then, 15 ml of 5-vinyl-2-norbornene were added to conduct a polymerization reaction at 80°C for 24 hours. After completion of the reaction, the reaction mixture was poured into a large amount of methanol to deposit a polymer formed. The polymer was collected by filtration, washed and then dried under reduced pressure, thereby obtaining 2.8 g of a polymer (Mn = 45,000, Tg = 135°C).

Dissolved in 100 parts by weight of xylene were 50 parts by weight of the thus-obtained polymer at 130°C, and 2 parts by weight of t-butyl hydroperoxide and 0.15 parts by weight of hexacarbonylmolybdenum were added to the solution to conduct a reaction for 1 hour. The resultant solution of a reaction product was poured into methanol to deposit a polymer formed. The polymer was collected by filtration, washed and then dried under reduced pressure, thereby obtaining 50 parts by weight of modified Polymer (Q). This modified Polymer Q had Mn of 48,200 and Tg of 246°C.

The conversion of carbon-carbon unsaturated bonds into the epoxy group, epoxy group content per repeating structural unit of the polymer and percent retention of carbon-carbon double bonds in the modified Polymer Q were 85%, 85 mol% and 15 mol%, respectively, as measured by $^1$H-NMR.

Table 3

| | Polymer composition (mol%) | Polymerization method | Tg (°C) | Molecular weight Mn x $10^4$ | Modifying group | Modification rate (%) | Tg (°C) | Molecular weight after modification Mn x $10^4$ | Code No. |
|---|---|---|---|---|---|---|---|---|---|
| Ex. 9 | NB (100) | Addition | 267 | 0.56 | Epoxy | 5.5 | 267 | 0.61 | I |
| Ex. 10 | TCD (100) | Addition | 340 | 2.10 | Epoxy | 12.8 | 342 | 2.19 | J |
| Ex. 11 | NB/DNB (76/24) | Addition | 260 | 6.92 | Epoxy | 9.0 | 263 | 7.40 | K |
| Ex. 12 | NB (100) | Addition | 267 | 0.56 | Maleic | 10.0 | 269 | 0.68 | L |
| Ex. 13 | NB/HNB/ENB (74/23/3) | Addition | 323 | 7.11 | Epoxy | 11.0 | 327 | 7.53 | M |
| Comp. Ex. 9 | NB/ethylene (56/44) | Addition | 148 | 4.82 | - | - | - | - | O |
| Comp. Ex. 10 | TCD/ethylene (45/55) | Addition | 148 | 4.62 | Epoxy | 1.2 | 148 | 4.71 | P |
| Comp. Ex. 11 | VNB (100) | Addition | 135 | 4.50 | Epoxy | 85 (*1) | 246 | 4.82 | Q |

(Note)

(*1) Modification by epoxidation of carbon-carbon double bonds.

[Examples 14 to 18]

Thirty parts by weight of each of the modified polymers obtained in Examples 9 to 13 and 1.2 parts by weight of 4,4'-bisazidobenzal(4-methyl)cyclohexanone were dissolved in 100 parts by weight of xylene. Each solution was provided as a uniform solution without forming any precipitate.

This uniform solution was then coated on a silicon wafer, in which an aluminum wiring had been formed on an $SiO_2$ film 4000 Å thick, by a spin coating method, and the thus-coated solution was prebaked at 90°C for 60 seconds, thereby forming a coating film 3.3 μm thick on the aluminum wiring. Each sample thus obtained was cured at 250°C for 3 hours under nitrogen, thereby forming an overcoat 3 μm thick to evaluate it as to dielectric constant, dielectric loss tangent, adhesion property, soldering heat resistance and durability (heat resistance and moisture resistance). The results are shown in Table 4.

[Comparative Example 12]

After 50 parts by weight of the polymer obtained in Comparative Example 9 were dissolved in 100 parts by weight of xylene, 2 parts by weight of t-butyl hydroperoxide and 0.5 parts by weight of triallyl isocyanurate were added to obtain a colorless and transparent uniform solution.

This uniform solution was then coated on a silicon wafer, in which an aluminum wiring had been formed on an $SiO_2$ film 4000 Å thick, by a spin coating method, and the thus-coated solution was prebaked at 90°C for 60 seconds, thereby forming a coating film 3.3 μm thick on the aluminum wiring. This sample was cured at 250°C for 3 hours under nitrogen, thereby forming an overcoat 3 μm thick to evaluate it as to dielectric constant, dielectric loss tangent, adhesion property, soldering heat resistance and durability. The results are shown in Table 4.

[Comparative Example 13]

An overcoat was formed in the same manner as in Comparative Example 12 except that the polymer obtained in Comparative Example 10 was used, thereby evaluating it as to dielectric constant, dielectric loss tangent, adhesion property, soldering heat resistance and durability. The results are shown in Table 4.

[Comparative Example 13]

An overcoat was formed in the same manner as in Comparative Example 12 except that the polymer obtained in Comparative Example 11 was used, thereby evaluating it as to dielectric constant, dielectric loss tangent, adhesion property, soldering heat resistance and durability. The results are shown in Table 4.

Table 4

| | Soldering heat resistance | Adhesion property to alumin. wiring-formed silicon wafer | Change in metal layer after durability test | Dielec. loss tangent | Dielec. const. (1 MHz) | Code No. |
|---|---|---|---|---|---|---|
| Ex. 14 | Good | 100/100 | Not changed | 0.0009 | 2.3 | I |
| Ex. 15 | Good | 100/100 | Not changed | 0.0009 | 2.3 | J |
| Ex. 16 | Good | 100/100 | Not changed | 0.0009 | 2.3 | K |

Table 4 (continued)

| | Soldering heat resistance | Adhesion property to alumin. wiring-formed silicon wafer | Change in metal layer after durability test | Dielec. loss tangent | Dielec. const. (1 MHz) | Code No. |
|---|---|---|---|---|---|---|
| Ex. 17 | Good | 100/100 | Not changed | 0.0009 | 2.3 | L |
| Ex. 18 | Good | 100/100 | Not changed | 0.0009 | 2.3 | M |
| Comp. Ex. 12 | Poor | 20/100 | Not changed | 0.0007 | 2.2 | O |
| Comp. Ex 13 | Poor | 60/100 | Not changed | 0.0009 | 2.3 | P |
| Comp. Ex. 14 | Good | 100/100 | Corroded and tarnished | 0.0030 | 2.8 | Q |

It is understood from the results shown in Table 4 that when the modified polymers according to the present invention are used, overcoats (or interlayer insulating films) excellent in soldering heat resistance, adhesion property, durability, electrical properties and the like can be obtained.

[Example 19]

Epoxy-modified Polymer (R) was obtained in the same manner as in Example 1 except that the feed rate of hydrogen was changed from 1.5 liters/hr to 0.5 liters/hr, and the amounts of allyl glycidyl ether and dicumyl peroxide were changed from 100 parts by weight to 30 parts by weight and from 1.0 part by weight to 8 parts by weight, respectively. The result of the synthesis is shown in Table 5.

[Example 20]

Maleic anhydride-modified Polymer (S) was obtained in the same manner as in Example 19 except that allyl glycidyl ether was changed to maleic anhydride. The result of the synthesis is shown in Table 5.

[Comparative Example 15]

Unmodified Polymer (T) was obtained in the same manner as in Example 19 except that no epoxy modification was conducted. The result of the synthesis is shown in Table 5.

Table 5

| | Polymer composition (mol%) | Polymerization method | Tg (°C) | Molecular weight | | Modifying group | Modification rate (%) | Tg (°C) | Molecular weight after modification | | Code No. |
|---|---|---|---|---|---|---|---|---|---|---|---|
| | | | | Mn x $10^4$ | Mw x $10^4$ | | | | Mn x $10^4$ | Mw x $10^4$ | |
| Ex. 19 | TCD/ethylene (38/62) | Addition | 135 | 2.40 | 5.18 | Epoxy | 12 | 159 | 2.42 | 4.98 | R |
| Ex. 20 | TCD/ethylene (38/62) | Addition | 135 | 2.40 | 5.18 | Maleic | 15 | 155 | 2.66 | 5.68 | S |
| Comp. Ex. 15 | TCD/ethylene (38/62) | Addition | 135 | 2.40 | 5.18 | - | - | - | - | - | T |

[Examples 21 and 22]

Thirty parts by weight of each of the modified polymers obtained in Examples 19 and 20 and 1.2 parts by weight of 4,4'-bisazidobenzal(4-methyl)cyclohexanone were dissolved in 100 parts by weight of xylene. Each solution was provided as a uniform solution without forming any precipitate.

This uniform solution was then coated on a silicon wafer, in which an aluminum wiring had been formed on an $SiO_2$ film 4000 Å thick, by a spin coating method, and the thus-coated solution was prebaked at 90°C for 60 seconds, thereby forming a coating film 3.3 μm thick on the aluminum wiring. Each sample thus obtained was cured at 250°C for 3 hours under nitrogen, thereby forming an overcoat 3 μm thick to evaluate it as to dielectric constant, dielectric loss tangent, adhesion property, soldering heat resistance and durability (heat resistance and moisture resistance). The results are shown in Table 6.

[Comparative Example 16]

An experiment was conducted in the same manner as in Examples 21 and 22 except that the polymer obtained in Comparative Example 15 was used. The results are shown in Table 6.

Table 6

| | Soldering heat resistance | Adhesion property to alumin. wiring-formed silicon wafer | Change in metal layer after durability test | Dielec. loss tangent | Dielec. const. (1 MHz) | Code No. |
|---|---|---|---|---|---|---|
| Ex 21 | Good | 100/100 | Not changed | 0.0009 | 2.3 | R |
| Ex. 22 | Good | 100/100 | Not changed | 0.0009 | 2.3 | S |
| Comp. Ex. 16 | Partially deformed | 3/100 | Corroded and tarnished | 0.0007 | 2.2 | T |

It is understood from the results shown in Table 6 that when the modified polymers according to the present invention are used, overcoats (or interlayer insulating films) excellent in soldering heat resistance, adhesion property, durability, electrical properties and the like can be obtained.

[Examples 23 and 24]

Respective experiments were conducted in the same manner as in Examples 14 and 15 except that a substrate, in which a copper wiring had been formed on a polyimide film 10 μm thick, was used in place of the aluminum wiring-formed silicon wafer, thereby forming respective overcoats having a thickness of 3 μm. A cross-cut peel strength test as to the adhesion property of the overcoats to the copper wiring and polyimide film was conducted to make evaluation. As a result, it was founded to be 100/100 in any case.

[Comparative Example 17]

An experiment was conducted in the same manner as in Examples 23 and 24 except that the unmodified Polymer O was used, thereby forming an overcoat having a thickness of 3 μm. A cross-cut peel strength test as to the adhesion property of the overcoat to the copper wiring and polyimide film to make evaluation. As a result, it was founded to be 20/100.

〈INDUSTRIAL APPLICABILITY〉

According to the present invention, there are provided modified thermoplastic norbornene polymers excellent in electrical properties such as dielectric constant and dielectric loss tangent and also in adhesion property to other materials such as metals and silicon wafers, a production process thereof, crosslinking polymer compositions comprising such a modified thermoplastic norbornene polymer and a crosslinking agent, moldings thereof, and sheets, prepregs, laminates and the like using such a composition. The modified thermoplastic norbornene polymers and compositions comprising such a polymer according to the present invention can be applied to a wide variety of fields

such as circuits boards, interlayer insulating films, semiconductor devices and electronic parts in precision apparatus such as electronic computers and communication machines.

**Claims**

1. A modified thermoplastic norbornene polymer obtained by graft-modifying a norbornene addition polymer having repeating units [A] represented by the formula (A1):

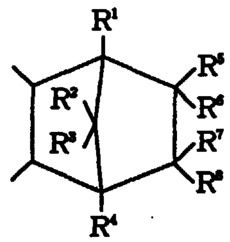

(A1)

wherein $R^1$ to $R^8$ are independently a hydrogen atom, hydrocarbon group, halogen atom, alkoxy group, ester group, cyano group, amide group, imide group, silyl group or hydrocarbon group substituted by a polar group (i.e., a halogen atom, alkoxy group, ester group, cyano group, amide group, imide group or silyl group),
with the proviso that at least two of $R^5$ to $R^8$ may be bonded to each other to form a monocycle or polycycle, the monocycle or polycycle may have carbon-carbon double bond(s) or be in the form of an aromatic ring, and $R^5$ and $R^6$, or $R^7$ and $R^8$ may form an alkylidene group, with at least one unsaturated compound selected from the group consisting of unsaturated epoxy compounds and unsaturated carboxylic compounds, wherein the modified polymer has a rate of graft modification of 3 to 50 mol% when graft-modified with an unsaturated epoxy compound or a rate of graft modification of 7 to 50 mol% when graft-modified with an unsaturated carboxylic compound, and a number average molecular weight (Mn) of 500 to 500,000.

2. The modified thermoplastic norbornene polymer according to Claim 1, wherein the norbornene addition polymer is an addition copolymer of a norbornene monomer and a vinyl compound, which also has repeating units derived from the vinyl compound in addition to the repeating units [A].

3. The modified thermoplastic norbornene polymer according to Claim 2, wherein the norbornene addition polymer has at least 30 wt.% of the repeating units [A] derived from the norbornene monomer.

4. A process for producing a modified thermoplastic norbornene polymer, the process comprising addition-polymerizing a norbornene monomer represented by the formula (a1):

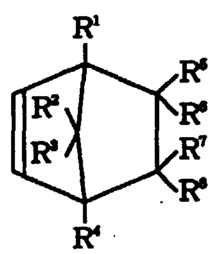

(a1)

wherein the respective meanings of the reference characters are as defined in the formula (A1), in the presence of a polymerization catalyst comprising a compound of a transition metal belonging to Group VIII of the periodic table as a main component, and then reacting the resultant norbornene addition polymer with at least one unsaturated compound selected from the group consisting of unsaturated epoxy compounds and unsaturated carboxylic compounds in the presence of an organic peroxide, thereby graft-modifying the addition polymer.

5. The production process according to Claim 4, wherein the rate of graft modification with the unsaturated epoxy compound is 3 to 50 mol%.

6. The production process according to Claim 4, wherein the rate of graft modification with the unsaturated carboxylic compound is 7 to 50 mol%.

7. A process for producing a modified thermoplastic norbornene polymer having a rate of graft modification of 3 to 50 mol% when graft-modified with an unsaturated epoxy compound or a rate of graft modification of 7 to 50 mol% when graft-modified with an unsaturated carboxylic compound, and a number average molecular weight (Mn) of 500 to 500,000, the process comprising reacting a norbornene addition (co)polymer obtained by addition-polymerizing a norbornene monomer, or a norbornene monomer and a vinyl compound and having a number average molecular weight (Mn) of 500 to 500,000 with at least one unsaturated compound selected from the group consisting of unsaturated epoxy compounds and unsaturated carboxylic compounds in the presence of an organic peroxide.

8. A crosslinking polymer composition comprising a modified thermoplastic norbornene polymer obtained by graft-modifying a norbornene addition polymer having repeating units [A] represented by the formula (A1):

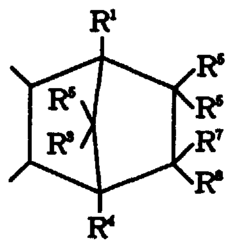

(A1)

wherein $R^1$ to $R^8$ are independently a hydrogen atom, hydrocarbon group, halogen atom, alkoxy group, ester group, cyano group, amide group, imide group, silyl group or hydrocarbon group substituted by a polar group (i.e., a halogen atom, alkoxy group, ester group, cyano group, amide group, imide group or silyl group),
with the proviso that at least two of $R^5$ to $R^8$ may be bonded to each other to form a monocycle or polycycle, the monocycle or polycycle may have carbon-carbon double bond(s) or be in the form of an aromatic ring, and $R^5$ and $R^6$, or $R^7$ and $R^8$ may form an alkylidene group, with at least one unsaturated compound selected from the group consisting of unsaturated epoxy compounds and unsaturated carboxylic compounds, and having a rate of graft modification of 3 to 50 mol% when graft-modified with an unsaturated epoxy compound or a rate of graft modification of 7 to 50 mol% when graft-modified with an unsaturated carboxylic compound, and a number average molecular weight (Mn) of 500 to 500,000, and a crosslinking agent.

9. The crosslinking polymer composition according to Claim 8, wherein the norbornene addition polymer is an addition copolymer of a norbornene monomer and a vinyl compound, which also has repeating units derived from the vinyl compound in addition to the repeating units [A].

10. The crosslinking polymer composition according to Claim 8 or 9, wherein the crosslinking agent is selected from ① an organic peroxide, ② a crosslinking agent capable of exhibiting its effect by heat or ③ a crosslinking agent capable of exhibiting its effect by light.

11. The crosslinking polymer composition according to any one of Claims 8 to 10, wherein the crosslinking agent is contained in a proportion of 0.001 to 30 parts by weight per 100 parts by weight of the modified thermoplastic norbornene polymer.

12. The crosslinking polymer composition according to any one of claims 8 to 11, which further comprises a crosslinking aid.

13. The crosslinking polymer composition according to any one of claims 8 to 12, which further comprises a flame retardant.

14. A molding obtained by molding the crosslinking polymer composition according to any one of Claims 8 to 13.

15. A laminate having a structure that a layer formed of the crosslinking polymer composition according to any one of Claims 8 to 13 is laminated on a metal layer.

16. A prepreg comprising a reinforcing base material impregnated with the crosslinking polymer composition according to any one of Claims 8 to 13.

## INTERNATIONAL SEARCH REPORT

International application No.
PCT/JP97/03933

**A. CLASSIFICATION OF SUBJECT MATTER**

Int. Cl$^6$ C08F277/00, 8/00, C08L51/00, C08J5/18, 5/24, B32B15/08

According to International Patent Classification (IPC) or to both national classification and IPC

**B. FIELDS SEARCHED**

Minimum documentation searched (classification system followed by classification symbols)

Int. Cl$^6$ C08F251/00-291/00, 8/00, C08L51/00, C08J5/18, 5/24, B32B15/08

Documentation searched other than minimum documentation to the extent that such documents are included in the fields searched

Electronic data base consulted during the international search (name of data base and, where practicable, search terms used)

**C. DOCUMENTS CONSIDERED TO BE RELEVANT**

| Category* | Citation of document, with indication, where appropriate, of the relevant passages | Relevant to claim No. |
|---|---|---|
| X<br>Y | JP, 62-27412, A (Mitsui Petrochemical Industries, Ltd.), February 5, 1987 (05. 02. 87), Claims & EP, 203799, A1 | 1 - 7<br>8 - 16 |
| X | JP, 3-185013, A (Mitsui Petrochemical Industries, Ltd.), May 13, 1991 (13. 05. 91), Claims (Family: none) | 1 - 7 |
| X<br>Y | JP, 3-188113, A (Mitsui Petrochemical Industries, Ltd.), August 16, 1991 (16. 08. 91), Claims (Family: none) | 1 - 7<br>8 - 16 |
| X | JP, 50-59488, A (Japan Synthetic Rubber Co., Ltd.), May 22, 1975 (22. 05. 75), Claims; page 2, lower right column, lines 9 to 16 (Family: none) | 1 - 7 |

[X] Further documents are listed in the continuation of Box C. [ ] See patent family annex.

* Special categories of cited documents:
- "A" document defining the general state of the art which is not considered to be of particular relevance
- "E" earlier document but published on or after the international filing date
- "L" document which may throw doubts on priority claim(s) or which is cited to establish the publication date of another citation or other special reason (as specified)
- "O" document referring to an oral disclosure, use, exhibition or other means
- "P" document published prior to the international filing date but later than the priority date claimed
- "T" later document published after the international filing date or priority date and not in conflict with the application but cited to understand the principle or theory underlying the invention
- "X" document of particular relevance; the claimed invention cannot be considered novel or cannot be considered to involve an inventive step when the document is taken alone
- "Y" document of particular relevance; the claimed invention cannot be considered to involve an inventive step when the document is combined with one or more other such documents, such combination being obvious to a person skilled in the art
- "&" document member of the same patent family

| Date of the actual completion of the international search | Date of mailing of the international search report |
|---|---|
| January 8, 1998 (08. 01. 98) | January 20, 1998 (20. 01. 98) |

| Name and mailing address of the ISA/ | Authorized officer |
|---|---|
| Japanese Patent Office | |
| Facsimile No. | Telephone No. |

Form PCT/ISA/210 (second sheet) (July 1992)

**INTERNATIONAL SEARCH REPORT**

International application No.
PCT/JP97/03933

C (Continuation). DOCUMENTS CONSIDERED TO BE RELEVANT

| Category* | Citation of document, with indication, where appropriate, of the relevant passages | Relevant to claim No. |
|---|---|---|
| Y | JP, 6-248164, A (Nippon Zeon Co., Ltd.), September 6, 1994 (06. 09. 94), Claims (Family: none) | 8 - 16 |

Form PCT/ISA/210 (continuation of second sheet) (July 1992)